# EUROPEAN PATENT APPLICATION

(11) **EP 4 700 882 A1**
(43) Date of publication of application: **25.02.2026**
(21) Application number: 24858259.5
(22) Date of filing: 08.08.2024
(51) Int. Cl.: H01M 10/0525, H01M 10/056

(54) **BATTERY, ELECTROLYTE SELECTION METHOD, ENERGY STORAGE APPARATUS, AND ELECTRICAL DEVICE**

(30) Priority: 28.08.2023 CN 202311088191; 29.12.2023 CN 202311867720
(71) Applicant: Xiamen Hithium Energy Storage Technology Co., Ltd., Xiamen, Fujian 361100 (CN)
(72) Inventor: JIA, Shize, Xiamen, Fujian 361000 (CN); LV, Tengxiao, Xiamen, Fujian 361000 (CN); KANG, Zhenhong, Xiamen, Fujian 361000 (CN)
(74) Representative: Mewburn Ellis LLP
(86) International application number: PCT/CN2024/110727
(87) International publication number: WO 2025/044716

(57) **Abstract**

A battery, an electrolyte selection method, an energy-storage apparatus, and an electricity-consumption device are provided in the disclosure. The battery includes an electrode assembly and an electrolyte. The electrode assembly includes a positive electrode, a separator, and a negative electrode which are stacked sequentially. The electrolyte at least infiltrates part of the electrode assembly, and the electrolyte contains a lithium salt. The positive electrode is obtained by disassembling the battery in a fully charged state, the positive electrode obtained and the electrolyte are assembled in a button cell, the button cell is subjected to a linear sweep voltammetry (LSV) test at a potential sweep rate of 0.1 mV/s, and a first peak current density *a1* of the button cell satisfies a relationship: 0.1mAcm^{-*2*}≤*a1*≤3mAcm⁻²*.* The battery herein has an excellent cycle performance and an excellent overcharge performance.

## Description

### CROSS-REFERENCE TO RELATED APPLICATION(S)

This application claims priority to Chinese Patent Application No. 202311088191.7, filed August 28, 2023, and entitled "BATTERY, ELECTROLYTE SELECTION METHOD, ENERGY-STORAGE APPARATUS, AND ELECTRICITY-CONSUMPTION DEVICE", and claims priority to Chinese Patent Application No. 202311867720.3, filed December 29, 2023, and entitled "BATTERY, ELECTROLYTE SELECTION METHOD, ENERGY-STORAGE APPARATUS, AND ELECTRICITY-CONSUMPTION DEVICE", which are incorporated herein by reference as if reproduced in their entireties.

### TECHNICAL FIELD

The disclosure relates to the field of energy storage technology, and particularly to a battery, an electrolyte selection method, an energy-storage apparatus, and an electricity-consumption device.

### BACKGROUND

With development of the energy-storage industry and continuous advancement of the lithium-ion battery technology, stricter requirements are imposed on lithium-ion energy-storage batteries in wind and solar power generation side and other user scenarios, demanding a lower life degradation rate and a longer service live. Meanwhile, cell safety serves as a foundational requirement (or bottom line) for operation of the energy-storage battery. With increasing size and centralization of energy-storage batteries, higher requirements are imposed on a safety performance of the batteries. However, with increasing energy density and cell integration of existing large-scale energy-storage batteries, heat generated by the cell is increasing, posing a growing challenge to maintain the foundational requirement of safety.

### SUMMARY

In view of the above, the disclosure provides a battery, an electrolyte selection method, an energy-storage apparatus, and an electricity-consumption device, and the battery has an excellent cycle performance and an excellent overcharge performance.

The disclosure provides a battery. The battery includes an electrode assembly and an electrolyte. The electrode assembly includes a positive electrode, a separator, and a negative electrode which are stacked sequentially. The electrolyte at least infiltrates part of the electrode assembly, and the electrolyte contains a lithium salt. The positive electrode is obtained by disassembling the battery in a fully charged state, the positive electrode obtained and the electrolyte are assembled in a button cell, the button cell is subjected to a linear sweep voltammetry (LSV) test at a potential sweep rate of 0.1 mV/s, and a first peak current density *a1* of the button cell satisfies a relationship: 0.1mAcm⁻²≤*a1*≤3mAcm⁻²*.*

Further, a first peak potential *PI* of the button cell satisfies: 4.65V≤*P1*≤4.9V.

Further, a second peak potential *P2* of the button cell satisfies: 3.3V≤*P2*≤4.0V.

Further, a second peak current density *a2* of the button cell satisfies: 0.3mAcm⁻²≤*a2*≤5mAcm⁻².

Further, a ratio of a second peak current density of the button cell to the first peak current density of the button cell satisfies: 0.1 *≤a2*/*a1*≤30.

Further, the electrolyte further contains a film-forming additive, and in the electrolyte, a mass fraction g of the film-forming additive satisfies a relationship: 2%≤*g*≤10%.

Further, the film-forming additive includes at least one of vinylene carbonate, fluoroethylene carbonate, vinyl sulfate, or 1,3-propene sultone.

Further, the positive electrode includes an active material layer and a current collector layer, the active material layer is disposed on the current collector layer, the active material layer contains a binder, and in the active material layer, a mass fraction *b* of the binder satisfies a relationship: 2%≤*b*≤4%.

Further, a ratio of the first peak current density *a1* of the button cell to the mass fraction *b* of the binder satisfies a relationship: 0.025mAcrri⁻²≤*a1*/*b*≤1mAcm⁻².

Further, a ratio of the first peak current density *a1* of the button cell to a unit reaction area c of the active material layer satisfies a relationship: 0.24mAm⁻²≤*a1*/*c*≤12.32mAm⁻², where the unit reaction area c of the active material layer is a product of a weight g of the active material layer per unit area and a specific surface area *BET* of the active material layer.

Further, the unit reaction area c of the active material layer satisfies a relationship: 0.1623m²·cm-²≤*c*≤0.416m²·cm⁻².

Further, the active material layer further contains an active material, the active material is lithium iron phosphate, and the current collector layer contains aluminum.

Further, the binder is polyvinylidene fluoride.

The disclosure further provides an electrolyte selection method. The electrolyte selection method includes: providing test batteries each comprising a positive electrode and an electrolyte; for each of the test batteries, charging the test battery until the test battery is in a fully charged state; for each of the test batteries, obtaining the positive electrode by disassembling the test battery, and assembling the positive electrode obtained, a lithium metal, and the electrolyte into a button cell in which the positive electrode serves as a working electrode and the lithium metal serves as a counter electrode; obtaining a first peak potential *P1* and a first peak current density *a1* of the button cell by performing an LSV test on the button cell; and selecting the electrolyte whose first peak potential *P1* satisfies a relationship: 4.65V≤*P1*≤4.9V, and whose first peak current density *a1* satisfies a relationship: 0.1mAcm⁻²≤*a1*≤3mAcm⁻²*.*

Further, the electrolyte selection method further includes: obtaining a second peak potential *P*2 and a second peak current density *a2* of the button cell; and selecting the electrolyte whose second peak potential *P*2 satisfies a relationship: 3.3V≤*P2*≤4.0V, and whose second peak current density *a2* satisfies a relationship: 0.3mAcm⁻²≤*a2*≤5mAcm⁻²*.*

Further, obtaining the first peak potential *P1* and the first peak current density *a1* of the button cell by performing the LSV test on the button cell includes: performing the LSV test on the button cell at a potential sweep rate of 0.1mV/s.

The disclosure further provides an energy-storage apparatus. The energy-storage apparatus includes multiple batteries provided in the disclosure. The multiple batteries are electrically connected to each other.

The disclosure further provides an electricity-consumption device. The electricity-consumption device includes a device body and the energy-storage apparatus provided in the disclosure. The energy-storage apparatus is configured to supply power to the device body.

In the disclosure, when the battery is in the fully charged state, the positive electrode and the negative electrode will continuously generate heat. By assembling the electrolyte and the positive electrode in a fully delithiated state into a button cell and performing an LSV test, a characteristic first peak can be obtained, which indicates that functional groups in the electrolyte such as double bonds and cyclic structures have a polymerization reaction to generate a passivation film attached to a surface of the positive electrode, so as to passivate a high-valence transition metal oxide on the positive electrode. In other words, the electrolyte has a function of passivating the positive electrode. When the electrolyte and the positive electrode are assembled in the battery and the battery is in an overcharged state, the electrolyte can generate the passivation film and passivate an interface between the positive electrode and the electrolyte, which can prevent solvent molecules in the electrolyte from directly contacting and continuing to react with the transition metal oxide on the positive electrode. As such, generation of reaction heat can be reduced, thermal runaway of the battery during overcharging can be avoided, risks of thermal runaway, fire, and explosion of the battery due to overcharging can be reduced, thereby improving a safety performance of the battery. The passivation film may be a chemical electrochemical interface (CEI) film. The generated CEI film can prevent the reaction between the electrolyte and the positive electrode, so as to avoid generating more reaction heat, which is beneficial to improving an overcharge performance of the battery. When the first peak current density *a1* of the button cell satisfies the relationship: 0.1mAcm⁻²≤*a1*≤3mAcm⁻², that is, the first peak current density *a1* of the button cell is within a reasonable range, the thickness of the passivation film generated in the battery during charging is within a reasonable range. The passivation film of such thickness can passivate the positive electrode on the one hand, and on the other hand, can avoid increase in resistance to migration of active ions in the electrolyte caused by the excessive thickness of the passivation film, avoid the passivation film blocking the reaction between the electrolyte and the positive electrode, and shorten the time during which the battery is overcharged, thereby avoiding generation of more reaction heat and Joule heat, and preventing the separator disposed between the positive electrode and the negative electrode from being melted and ruptured. As such, thermal runaway of the battery during overcharging can be avoided. When the first peak current density *a1* of the button cell is greater than 3mAcm⁻², that is, the value of the first peak current density *a1* of the button cell is excessively large, the thickness of the passivation film generated in the battery during charging is excessively large, and accordingly, the degree of passivation of the positive electrode by the electrolyte is excessively high, which leads to excessive resistance to migration of active ions in the electrolyte during continued charging of the battery, thereby generating Joule heat. As a result, the heat generated by the battery during overcharging is increased. When the first peak current density *a1* of the button cell is less than 0.1mAcm⁻², that is, the value of the first peak current density *a1* of the button cell is excessively small, the thickness of the passivation film generated in the battery during charging is excessively small, as a result, the passivation film cannot effectively passivate the positive electrode, so that the positive electrode can still react with the electrolyte to generate more reaction heat. In view of the above, the battery herein has an excellent cycle performance and an overcharge performance.

### BRIEF DESCRIPTION OF THE DRAWINGS

In order to describe technical solutions of embodiments of the disclosure more clearly, the following will give a brief description of accompanying drawings used for describing the embodiments. Apparently, accompanying drawings described below are merely some embodiments. Those of ordinary skill in the art can also obtain other accompanying drawings based on the accompanying drawings described below without creative efforts.
FIG. 1 is a schematic structural diagram illustrating a battery provided in embodiments of the disclosure.
FIG. 2 is an exploded schematic structural diagram illustrating a battery provided in embodiments of the disclosure.
FIG. 3 is a cross-sectional view of a battery provided in embodiments of the disclosure.
FIG. 4 is a cross-sectional view of a positive electrode in one embodiment of the present application.
FIG. 5 is a cross-sectional view of a negative electrode provided in embodiments of the disclosure.
FIG. 6 is a schematic flowchart illustrating an electrolyte selection method provided in embodiments of the disclosure.
FIG. 7 is a schematic flowchart illustrating an electrolyte selection method provided in other embodiments of the disclosure.
FIG. 8 is a schematic structural diagram illustrating an energy-storage apparatus provided in embodiments of the disclosure.
FIG. 9 is a circuit block diagram illustrating an electricity-consumption device provided in embodiments of the disclosure.
FIG. 10 is a schematic structural diagram illustrating an electricity-consumption device provided in embodiments of the disclosure.

Reference signs: 100-battery, 110-electrode assembly, 111-positive electrode, 1111-active material layer, 1112-current collector layer, 1113-single-sided area, 112-separator, 113-negative electrode, 1131-negative material layer, 1132-negative current collector layer, 120-end cover assembly, 130-electrical connector, 140-housing, 141-receiving chamber, 150-electrolyte, 200-energy-storage apparatus, 210-box, 211-accommodating chamber, 300-electricity-consumption device, 310-device body.

### DETAILED DESCRIPTION

Hereinafter, technical solutions of embodiments of the disclosure will be described clearly and completely with reference to accompanying drawings in the embodiments. Apparently, embodiments described below are merely some embodiments, rather than all embodiments of the disclosure. All other embodiments obtained by those of ordinary skill in the art based on the embodiments without creative efforts shall fall within the protection scope of the disclosure.

The terms "first", "second", and the like used in the specification, the claims, and the accompany drawings of the disclosure are used to distinguish different objects rather than describe a particular order. In addition, the terms "include", "comprise", and "have" as well as variations thereof are intended to cover non-exclusive inclusion. For example, a process, method, system, product, or device including a series of steps/operations or units is not limited to the listed steps/operations or units, on the contrary, it can optionally include other steps/operations or units that are not listed; alternatively, other steps/operations or units inherent to the process, method, product, or device can be included either.

The term "embodiment" referred to herein means that particular features, structures, or properties described in conjunction with the embodiments or implementations may be defined in at least one embodiment of the disclosure. The phrase "embodiment" appearing in various places in the specification does not necessarily refer to the same embodiment or an independent/ alternative embodiment that is mutually exclusive with other embodiments. Those skilled in the art will understand expressly and implicitly that an embodiment described herein may be combined with other embodiments.

Lithium iron phosphate is used as a positive active material in the majority of lithium-ion energy-storage batteries. The lithium iron phosphate has advantages of low oxygen release tendency, good electrochemical performance, and good thermal stability, but its energy density is relatively low. In order to improve the energy density of the lithium-ion energy-storage battery with the lithium iron phosphate as the positive active material, in the related technology, the energy density of the lithium-ion energy-storage battery is improved by increasing electrode coating thickness, raising cold-pressed density, and expanding cell capacity. However, the above strategies have made safety issues of the lithium-ion energy-storage battery increasingly prominent. The larger cell capacity will increase the heat generated by the cell, and during overcharging, the heat generated by the cell will continue to accumulate, which can easily trigger a chain reaction in a chemical system. Moreover, the continuous accumulation of reaction heat will increase risks of thermal runaway, fire, and even explosion of the lithium-ion energy-storage battery. In addition, as the reaction heat continues to accumulate, the separator between the positive electrode and the negative electrode is prone to be melted and broken, causing the positive electrode and the negative electrode to be shortcircuited, thereby causing the battery to experience thermal runaway, fire, or even explosion.

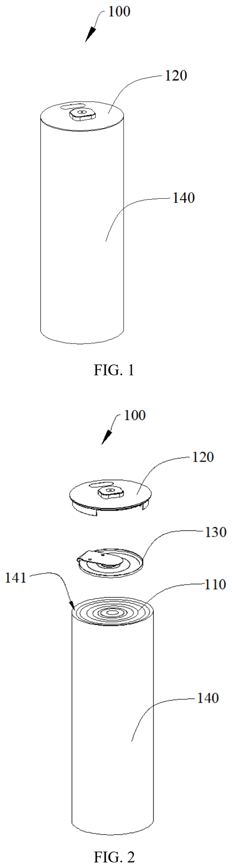

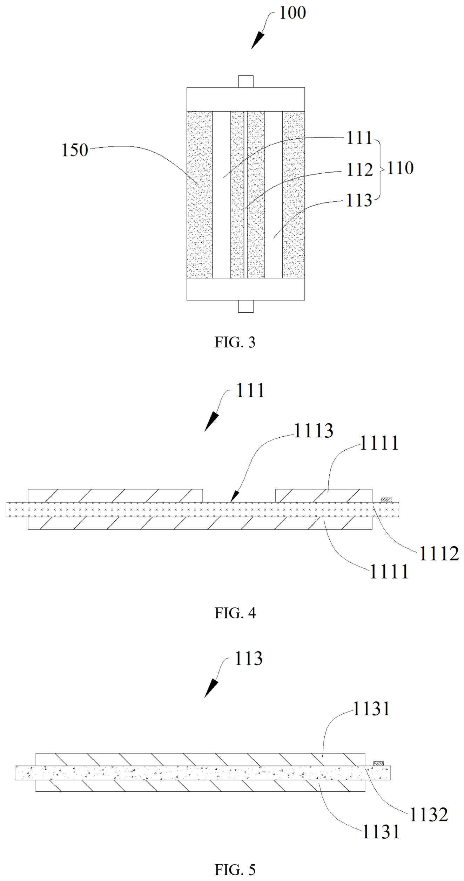

Referring to FIG. 1 to FIG. 4, in some embodiments, a battery 100 includes an electrode assembly 110 and an electrolyte 150. The electrode assembly 110 includes a positive electrode 111, a separator 112, and a negative electrode 113 which are stacked sequentially. The electrolyte 150 at least infiltrates part of the electrode assembly 110. The electrolyte 150 contains a lithium salt. The positive electrode 111 is obtained by disassembling the battery in a fully charged state, the positive electrode 111 obtained and the electrolyte 150 are assembled in a button cell, the button cell is subjected to a linear sweep voltammetry (LSV) test at a potential sweep rate of 0.1 mV/s, and a first peak current density *a1* of the button cell satisfies a relationship: 0.1 mAcm⁻²≤*a1*≤3 mAcm⁻².

It can be understood that, the positive electrode 111 is disposed on one side of the separator 112, and the negative electrode 113 is disposed on one side of the separator 112 away from the positive electrode 111.

It can be understood that, the electrolyte 150 contains a lithium salt, and the battery 100 is a lithium-ion battery 100, and the electrolyte 150 reacts with the electrode assembly 110 to generate active ions, that is, lithium ions.

Optionally, the positive electrode 111 contains a transition metal oxide. When the electrode assembly 110 and the electrolyte 150 are assembled in the battery 100, the electrode assembly 110 reacts with the electrolyte 150 to generate lithium ions, and the lithium ions are deintercalated from the positive electrode 111, migrate to the negative electrode 113 through the electrolyte 150, and are intercalated in the negative electrode 113, so as to realize charging of the battery 100. During discharging of the battery 100, lithium ions are deintercalated from the negative electrode 113, migrate to the positive electrode 111 through the electrolyte 150, and are intercalated in the positive electrode 111.

It can be understood that, the expression "the battery 100 in a fully charged state" means that the battery 100 is charged so that a voltage of the battery 100 reaches a rated voltage and a current of the battery 100 reaches a rated current. In this case, the positive electrode 111 of the battery 100 is in a fully delithiated state.

It can be understood that, the expression "the positive electrode 111 is obtained by disassembling the battery 100 in a fully charged state, the positive electrode 111 obtained and the electrolyte 150 are assembled in a button cell, the button cell is subjected to a linear sweep voltammetry (LSV) test at a potential sweep rate of 0.1 mV/s" means that: when the battery 100 is in the fully charged state, the positive electrode 111 is in the fully delithiated state, the battery 100 is disassembled, a single-sided area 1113 of the positive electrode 111 and the electrolyte 150 are assembled in the button cell, and the button cell is subjected to the LSV test at the potential sweep rate of 0.1 mV/s. Specifically, for the LSV test, the button cell includes a working electrode, a counter electrode, and the electrolyte 150, where the single-sided area 1113 of the positive electrode 111 is used as the working electrode, and in this case, the working electrode is in the fully delithiated state, a lithium metal is used as the counter electrode, and the electrolyte 150 infiltrates the working electrode and the counter electrode; a voltage is applied to the button cell through an electrochemical workstation; the first peak potential *P1* and the first peak current density *a1* of the button cell are obtained by performing the LSV test on the button cell at the potential sweep rate of 0.1 mV/s.

It can be understood that, the positive electrode 111 includes an active material layer 1111 and a current collector layer 1112. The active material layer 1111 is disposed on one surface of the current collector layer 1112 or disposed on two opposite surfaces of the current collector layer 1112. The single-sided area 1113 of the positive electrode 111 refers to an area in the positive electrode 111 where the active material layer 1111 is only disposed on one surface of the current collector layer 1112.

It can be understood that, the button cell has a first characteristic peak, which indicates that: when the battery 100 is in the fully charged state, functional groups in the electrolyte 150 such as double bonds and cyclic structures have a polymerization reaction to generate a flexible organic polymer and form a passivation film attached to a surface of the positive electrode 111, so that a high-valence transition metal oxide on the positive electrode 111 is passivated, which can prevent the electrolyte 150 from continuing to react with the positive electrode 111, thereby reducing generation of reaction heat.

It can be understood that, the first peak current density *a1* of the button cell may represent the degree of passivation of the positive electrode 111 by the electrolyte 150 when the battery 100 is in the fully charged state, or represent the amount of the generated flexible organic polymer. The larger value of *a1* enables the larger amount of the generated flexible organic polymer, making the formed passivation film denser, thereby increasing the degree of passivation of the positive electrode 111 by the electrolyte 150.

Specifically, the value of the first peak current density *a1* of the button cell may be, but is not limited to, 0.1 mAcm⁻², 0.2 mAcm⁻², 0.5 mAcm⁻², 0.7 mAcm⁻², 0.9 mAcm⁻², 1.0 mAcm⁻², 1.2 mAcm⁻², 1.3 mAcm⁻², 1.5 mAcm⁻², 1.7 mAcm⁻², 1.9 mAcm⁻², 2.0 mAcm⁻², 2.1 mAcm⁻², 2.3 mAcm⁻², 2.4 mAcm⁻², 2.6 mAcm⁻², 2.7 mAcm⁻², 2.8 mAcm⁻², 2.9 mAcm⁻², 3 mAcm⁻², etc.

In these embodiments, when the battery 100 is in the fully charged state, the positive electrode 111 and the negative electrode 113 will continuously generate heat. By assembling the electrolyte 150 and the positive electrode 111 in the fully delithiated state into the button cell and performing the LSV test, a characteristic first peak can be obtained, which indicates that functional groups in the electrolyte 150 such as double bonds and cyclic structures have a polymerization reaction to generate a flexible organic polymer and form a passivation film attached to a surface of the positive electrode 111, so as to passivate a high-valence transition metal oxide on the positive electrode 111. In other words, the electrolyte 150 has a function of passivating the positive electrode 111. When the electrolyte 150 and the positive electrode 111 are assembled in the battery 100 and the battery 100 is in an overcharged state, the electrolyte 150 can generate a passivation film and passivate an interface between the positive electrode 111 and the electrolyte 150, which can prevent solvent molecules in the electrolyte 150 from directly contacting and continuing to react with the transition metal oxide on positive electrode 111. As such, generation of reaction heat can be reduced, thermal runaway of the battery 100 during overcharging can be avoided, risks of thermal runaway, fire, or explosion of the battery 100 due to overcharging can be reduced, thereby improving a safety performance of the battery 100. The passivation film may be a chemical electrochemical interface (CEI) film. The generated CEI film can prevent the reaction of the electrolyte 150 and the positive electrode 111, so as to avoid generating more reaction heat, which is beneficial to improving an overcharge performance of the battery 100. When the first peak current density *a1* of the button cell satisfies the relationship: 0.1mAcm⁻²≤*a1*≤3mAcm⁻², that is, the first peak current density *a1* of the button cell is within a reasonable range, the thickness of the passivation film generated by the electrolyte 150 during charging is within a reasonable range. The passivation film of such thickness can passivate the positive electrode 111 on the one hand, and on the other hand, can avoid increase in resistance to migration of active ions in the electrolyte 150 caused by the excessive thickness of the passivation film, avoid the passivation film blocking the reaction between the electrolyte 150 and the positive electrode 111, and shorten the time during which the battery 100 is overcharged, thereby avoiding generation of more reaction heat and Joule heat, and preventing the separator 112 disposed between the positive electrode 111 and the negative electrode 113 from being melted and ruptured. As such, thermal runaway in the battery 100 during overcharging can be avoided. In addition, the amount of the flexible organic polymer generated by the electrolyte 150 is sufficient, so that the formed passivation film is sufficiently dense, which is beneficial to improving an effect of passivation of the high-valence transition metal oxide on the positive electrode 111 by the passivation film. When the first peak current density *a1* of the button cell is greater than 3mAcm⁻², that is, the value of the first peak current density *a1* of the button cell is excessively large, the thickness of the passivation film generated in the battery 100 during charging is excessively large, and accordingly, the degree of passivation of the positive electrode 111 by the electrolyte 150 is excessively high, which leads to excessive resistance to migration of active ions in the electrolyte during continued charging of the battery, thereby generating Joule heat. As a result, the heat generated by the battery 100 during overcharging is increased. When the first peak current density *a1* of the button cell is less than 0.1 mA cm⁻², that is, the value of the first peak current density *a1* of the button cell is excessively small, the thickness of the passivation film generated in the battery 100 during charging is excessively small, as a result, the passivation film cannot effectively passivate the positive electrode 111, so that the positive electrode 111 can still react with the electrolyte 150 to generate more reaction heat. In view of the above, the battery 100 herein has an excellent cycle performance and an overcharge performance.

In the disclosure, the term "reaction heat" refers to heat released or absorbed during a chemical reaction between the active ions and the transition metal oxide in the battery 100 during charging or discharging of the battery 100. The term "Joule heat" refers to heat generated when active ions and/or electrons migrate inside the battery 100, that is, heat produced by current flowing within the battery 100.

Optionally, in some embodiments, the battery 100 is a cylindrical battery 100. In other embodiments, the battery 100 is a square column battery 100.

Optionally, the battery 100 further includes an end cover assembly 120, an electrical connector 130, and a housing 140. The housing 140 encloses a receiving chamber 141 to receive the electrode assembly 110 and the electrolyte 150. The end cover assembly 120 is electrically connected with the electrode assembly 110 via the electrical connector 130. The end cover assembly 120 is connected with the housing 140 to close the receiving chamber 141.

In these embodiments, the housing 140 encloses the receiving chamber 141 to accommodate the electrode assembly 110 and the electrolyte 150. The electrolyte 150 is injected into the receiving chamber 141, to make the electrolyte 150 infiltrate the electrode assembly 110. The electrode assembly 110 reacts with the electrolyte 150 to achieve deintercalation or intercalation of active ions, thereby achieving charging or discharging of the battery 100. Two opposite ends of the electrical connector 130 are electrically connected to the end cover assembly 120 and the electrode assembly 110, respectively, so that electric energy generated by the electrode assembly 110 is transmitted to the outside through the electrical connector 130 and the end cover assembly 120, and external electric energy can also be transmitted to the electrode assembly 110 through the end cover assembly 120 and the electrical connector 130, thereby achieving discharging and charging of the battery 100.

In some embodiments, the first peak potential *P1* of the button cell satisfies: 4.65V≤*P1*≤4.9V. Specifically, the value of the first peak potential *P1* of the button cell may be, but is not limited to, 4.65V, 4.68V, 4.69V, 4.7V, 4.72V, 4.74V, 4.76V, 4.79V, 4.8V, 4.82V, 4.84V, 4.85V, 4.86V, 4.87V, 4.88V, 4.89V, 4.9V, etc.

In these embodiments, when the first peak potential *P1* of the button cell satisfies 4.65V≤*P1*≤ 4.9V, which indicates that: when the battery 100 is in the overcharged state, functional groups in the electrolyte 150 such as double bonds and cyclic structures have a polymerization reaction to generate a flexible organic polymer and form a passivation film attached to a surface of the positive electrode 111, so that a high-valence transition metal oxide on the positive electrode 111 is passivated. Further, the transition metal oxide on the positive electrode 111 cannot react with the lithium salt in the electrolyte 150 due to blocking of the passivation film, thereby reducing generation of reaction heat, which is beneficial to reducing occurrence of thermal runaway of the battery 100 in the overcharged state. In the battery 100, when the battery 100 is in the overcharged state, the electrolyte 150 can generate the passivation film, which can reduce generation of reaction heat, so that thermal runaway of the battery 100 caused by heat accumulation can be avoided, thereby reducing risks of fire or explosion of the battery 100, and improving a safety performance of the battery 100.

In some embodiments, the second peak potential *P2* of the button cell satisfies: 3.3V≤*P2*≤4.0V. Specifically, the value of the second peak potential *P2* may be, but is not limited to, 3.3V, 3.35V, 3.4V, 3.45V, 3.5V, 3.55V, 3.6V, 3.65V, 3.7V, 3.75V, 3.8V, 3.85V, 3.9V, 3.95V, 4.0V, etc.

It can be understood that, the button cell has a second characteristic peak, which indicates that: when the battery 100 is in the fully charged state, the electrolyte 150 and the positive electrode 111 have an oxidation reaction to generate an inorganic salt compound with good rigidity, and the generated inorganic salt compound combines with the flexible organic polymer to form a passivation film which has a better structural strength and is attached to a surface of the positive electrode 111, so that a high-valence transition metal oxide on the positive electrode 111 is passivated, which can prevent the electrolyte 150 from continuing to react with the positive electrode 111, thereby reducing generation of reaction heat.

It can be understood that, a peak potential of the second characteristic peak is different from that of the first characteristic peak.

In these embodiments, when the second peak potential *P2* of the button cell satisfies 3.3V≤*P2*≤ 4.0V, which indicates that: the electrolyte 150 and the positive electrode 111 in the battery 100 in the overcharged state have an oxidation reaction to generate an inorganic salt compound with good rigidity, and the generated inorganic salt compound combines with the flexible organic polymer to form a passivation film which has a better structural strength and is attached to a surface of the positive electrode 111, so that a high-valence transition metal oxide on the positive electrode 111 is passivated, which can prevent the electrolyte 150 from continuing to react with the positive electrode 111, thereby reducing generation of reaction heat. Furthermore, combination of the flexible organic polymer and the rigid inorganic salt compound enables the formed passivation film to have a high compactness and a good structural strength, so that the reaction between the transition metal oxide on the positive electrode 111 and the lithium salt in the electrolyte 150 is better prevented, thereby significantly reducing generation of reaction heat, which is conducive to further improving occurrence of thermal runaway of the battery 100 in the overcharged state. In the battery 100, when the battery 100 is in the overcharged state, the electrolyte 150 can generate the passivation film with a good structural strength and a good compactness, which can reduce generation of reaction heat, so that thermal runaway of the battery 100 caused by heat accumulation can be avoided, thereby reducing risks of fire or explosion of the battery 100, and improving a safety performance of the battery 100.

In some embodiments, the second peak current density *a2* of the button cell satisfies: 0.3mAcm⁻² ≤*a2*≤5mAcm⁻²*.* Specifically, the value of the second peak current density *a2* of the button cell may be, but is not limited to, 0.3mAcm⁻², 0.5mAcm⁻², 0.8mAcm⁻², 1.0mAcm⁻², 1.2mAcm⁻², 1.5mAcm⁻², 1.8mAcm⁻², 2.0mAcm⁻², 2.3mAcm⁻², 2.7mAcm⁻², 3.0mAcm⁻², 3.2mAcm⁻², 3.4mAcm⁻², 3.8mAcm⁻², 4.0mAcm⁻², 4.5mAcm⁻², 5mAcm⁻², etc.

It can be understood that, the second peak current density *a2* of the button cell may represent the degree of passivation of the positive electrode 111 by the electrolyte 150 when the battery 100 is in the fully charged state, or represent the amount of the generated rigid inorganic salt compound. The larger value of *a2* enables the larger amount of the generated rigid inorganic salt compound, and the combination of the rigid inorganic salt compound and the flexible organic polymer is beneficial to enhancing the structural strength of the formed passivation film, thereby increasing the degree of passivation of the positive electrode 111 by the electrolyte 150.

In these embodiments, when the second peak current density *a2* of the button cell satisfies 0.3mAcm⁻²≤*a2*≤5mAcm⁻²*,* that is, the second peak current density *a2* of the button cell is within a reasonable range, the amount of the rigid inorganic salt compound generated by the electrolyte 150 during overcharging is within a reasonable range, so that the generated passivation film has a thickness within a reasonable range and possesses a good structural strength. As such, on the one hand, such passivation film can passivate the positive electrode 111 and avoid increase in resistance to migration of active ions in the electrolyte 150 caused by the excessive thickness of the passivation film; on the other hand, such passivation film has a relatively high structural strength, which can avoid cracking of the passivation film due to its low structural strength, thereby ensuring an effect of passivation of the positive electrode 111 by the passivation film. When the electrolyte 150 is applied to the battery 100 and the battery 100 is in the overcharged state, the electrolyte 150 can generate the passivation film, which can prevent the reaction between the electrolyte 150 and the positive electrode 111, and shorten the time during which the battery 100 is overcharged, thereby avoiding generation of more reaction heat and Joule heat, and preventing the separator 112 disposed between the positive electrode 111 and the negative electrode 113 from being melted and ruptured, and thus avoiding thermal runaway of the battery 100 during overcharging. When the second peak current density *a2* of the button cell is excessively large, the amount of the rigid inorganic salt compound generated by the electrolyte 150 during overcharging is excessively large. When the excessive rigid inorganic salt compound is combined with the flexible organic polymer to generate the passivation film, the generated passivation film is too rough and not dense, resulting in decrease in the effect of passivation of the positive electrode 111 by the passivation film, thereby reducing an overcharge performance of the electrolyte 150. When the second peak current density *a2* of the button cell is excessively small, the amount of the rigid inorganic salt compound generated by the electrolyte 150 during overcharging is excessively small. When the insufficient rigid inorganic salt compound is combined with the flexible organic polymer to form the passivation film, the generated passivation film has a low structural strength, resulting in an increased risk of the passivation film being cracked in subsequent charge and discharge cycles, so that the passivation film cannot guarantee the effect of passivation of the positive electrode 111, thereby increasing a risk of thermal runaway of the battery 100 during overcharging.

In some embodiments, a ratio of the second peak current density of the button cell to the first peak current density of the button cell satisfies: 0.1 *≤a2*/*a1*≤30. Specifically, the value of *a2*/*a1* may be, but is not limited to, 0.1, 0.5, 1, 1.5, 2, 5, 6, 8, 10, 12, 13, 15, 16, 18, 20, 22, 23, 25, 26, 27, 28, 29, 30, etc.

In these embodiments, when the ratio of the second peak current density of the button cell to the first peak current density of the button cell satisfies: 0.1 *≤a2*/*a1*≤30, the ratio of the second peak current density of the button cell to the first peak current density of the button cell is within a reasonable range. When the electrolyte 150 is in the overcharged state, the amount of the flexible organic polymer generated by the electrolyte 150 and the amount of the rigid inorganic salt compound generated by the electrolyte 150 each are within a reasonable range, so that the formed passivation film has a high compactness and a good structural strength, which can improve an effect of passivation of the positive electrode 111, thereby preventing solvent molecules in the electrolyte 150 from directly contacting and continuing to react with the transition metal oxide on the positive electrode 111. As such, generation of reaction heat can be reduced, which can avoid thermal runaway of the battery 100 during overcharging, thereby reducing risks of thermal runaway, fire, or explosion of the battery 100 due to overcharging, and improving a safety performance of the battery 100. When the value of *a2*/*a1* is excessively large, the amount of the rigid inorganic salt compound generated by the electrolyte 150 under the overcharged state is much larger than the amount of the flexible organic polymer generated by the electrolyte 150 under the overcharged state, so that the generated passivation film is too rough and not dense, resulting in decrease in an effect of passivation of the positive electrode 111 by the passivation film, thereby reducing an overcharge performance of the electrolyte 150. When the value of *a2*/*a1* is excessively small, the amount of the rigid inorganic salt compound generated by the electrolyte 150 under the overcharged state is much smaller than the amount of the flexible organic polymer generated by the electrolyte 150 under the overcharged state, so that the generated passivation film has a low structural strength, resulting in an increased risk of the passivation film being cracked in subsequent charge and discharge cycles, so that the passivation film cannot guarantee the effect of passivation of the positive electrode 111, thereby increasing a risk of thermal runaway of the battery 100 in the overcharged state.

In some embodiments, the electrolyte further contains a film-forming additive, and in the electrolyte, a mass fraction g of the film-forming additive satisfies a relationship: 2% ≤*g*≤10%. Specifically, the mass fraction g of the film-forming additive may be, but is not limited to, 2%, 2.2%, 2.4%, 2.8%, 3%, 3.2%, 3.5%, 3.8%, 4%, 4.2%, 4.5%, 4.6%, 4.8%, 5%, 5.2%, 5.6%, 5.8%, 6%, 6.2%, 6.5%, 6.8%, 7%, 7.2%, 7.5%, 7.8%, 8%, 8.5%, 8.9%, 9%, 9.2%, 9.4%, 9.6%, 10%, etc.

In these embodiments, the electrolyte further contains the film-forming additive, and the mass fraction g of the film-forming additive satisfies a range of 2%≤*g*≤10%, that is, the mass fraction of the film-forming additive is within a reasonable range, so that the film-forming additive is conducive to promoting formation of the passivation film and maintaining stability of the passivation film, which improves an effect of passivation of the positive electrode 111 by the passivation film, thereby preventing the solvent molecules in the electrode 150 from directly contacting and continuing to react with the transition metal oxide on the positive electrode 111. As such, generation of reaction heat can be reduced, which can avoid thermal runaway of the battery 100 during overcharging, thereby reducing risks of thermal runaway, fire, or explosion of the battery 100 due to overcharging, and improving a safety performance of the battery 100.

Optionally, in some embodiments, the film-forming additive includes at least one of vinylene carbonate, fluoroethylene carbonate, vinyl sulfate, or 1,3-propene sultone.

In these embodiments, at least one of vinylene carbonate, fluoroethylene carbonate, vinyl sulfate, or 1,3-propene sultone can be used as the film-forming additive to promote formation of the passivation film, which can prevent the solvent molecules in the electrolyte 150 from directly contacting and continuing to react with the transition metal oxide on the positive electrode 111. As such, generation of reaction heat can be reduced, which can avoid thermal runaway of the battery 100 during overcharging, thereby improving a safety performance of the battery 100.

In some embodiments, the positive electrode 111 includes an active material layer 1111 and a current collector layer 1112. The active material layer 1111 is disposed on the current collector layer 1112. The active material layer 1111 contains a binder, and in the active material layer 1111, a mass fraction b of the binder satisfies a relationship: 2%≤*b*≤4%. Specifically, the mass fraction b of the binder may be, but is not limited to, 2%, 2.2%, 2.3%, 2.4%, 2.6%, 2.7%, 2.9%, 3%, 3.1%, 3.2%, 3.4%, 3.5%, 3.6%, 3.7%, 3.8%, 3.9%, 4%, etc.

It can be understood that, the expression "the active material layer 1111 is disposed on the current collector layer 1112" may mean that: the active material layer 1111 is disposed on one surface of the current collector layer 1112, or the active material layer 1111 is disposed on two opposite surfaces of the current collector layer 1112.

It can be understood that, the mass fraction b of the binder may be a ratio of a mass of the binder in the active material layer 1111 to a mass of the active material layer 1111.

In these embodiments, the binder can enhance bonding adhesion of other substances within the active material layer 1111. When the mass fraction b of the binder satisfies the relationship 2%≤*b*≤4%, that is, the mass fraction of the binder is within a reasonable range, a mass proportion of the binder in the active material layer 1111 is relatively high, which reduces a contact area between the transition metal oxide in the active material layer 1111 and the electrolyte 150, thereby further reducing the reaction heat of the positive electrode 111 and the electrolyte 150 under the overcharged state. In addition, by incorporating a relatively larger amount of binders in the active material layer 1111, the reaction between the electrolyte 150 and the positive electrode 111 under the overcharged state can be further rapidly impeded, which is beneficial to shortening the time of continued reaction of the battery 100 in the overcharged state, and accordingly, reducing Joule heat generated under the overcharged state, thereby further improving the overcharge performance of the battery 100. When the value of the mass fraction b of the binder is greater than 4%, the mass fraction of the binder is excessively large. Due to poor electrical conductivity of the binder, when the mass of the binder accounts for a large proportion of the mass of the active material layer 1111, impedance of the active material layer 1111 is increased, making it difficult for electrons to migrate in the active material layer 1111, and making it difficult for active ions to be deintercalated from the active material layer 1111, resulting in increase in Joule heat of the battery 100 and increase in the heat generated by the battery 100 in the overcharged state, thereby increasing risks of thermal runaway, fire, or explosion of the battery 100 caused by excessive heat. When the value of the mass fraction b of the binder is less than 2%, the mass fraction of the binder is excessively small. When the mass of the binder accounts for a small proportion of the active material layer 1111, the contact area between the transition metal oxide in the active material layer 1111 and the electrolyte 150 is still relatively large, as a result, the binder is difficult to prevent the positive electrode 111 from reacting with the electrolyte 150 under the overcharged state, which prolongs time of continued reaction of the battery 100 in the overcharged state, and accordingly, more Joule heat and reaction heat are generated, thereby increasing risks of thermal runaway, fire, or explosion of the battery 100 caused by excessive heat.

In some embodiments, the binder is polyvinylidene fluoride (PVDF).

In these embodiments, the binder is the PVDF, which has high oxidation resistance. Such binder can not only enhance bonding adhesion of other substances within the active material layer 1111, but also improve oxidation resistance of the positive electrode 111, thereby extending a service life of the positive electrode 111.

In some embodiments, the active material layer 1111 further contains an active material, the active material is lithium iron phosphate, and the current collector layer 1112 contains aluminum.

In these embodiments, the active material is lithium iron phosphate. When the electrode assembly 110 and the electrolyte 150 are assembled in the battery 100, the active material (i.e., lithium iron phosphate) of the positive electrode 111 reacts with the electrolyte 150 to generate lithium ions. The lithium ions are deintercalated from the positive electrode 111, migrate to the negative electrode 113 through the electrolyte 150, and are intercalated in the negative electrode 113, so as to realize charging of the battery 100. The current collector layer 1112 contains aluminum, and is configured to collect a current generated by the active material in the active material layer 1111 to generate a larger output current. The active material is lithium iron phosphate, so that the positive electrode 111 has advantages of low oxygen release tendency, good electrochemical stability, and good thermal stability, thereby improving a safety performance of the battery 100.

Optionally, the active material layer 1111 further contains a conductive agent. The conductive agent enables the positive electrode 111 to have a good charge and discharge performance, facilitates migration of electrons in the active material layer 1111, and helps reduce a migration rate of the electrons in the active material layer 1111.

Optionally, the conductive agent includes one or more of acetylene black, conductive carbon black, carbon nanotubes, carbon fibers, graphene, etc.

In some embodiments, a ratio of the first peak current density *a1* of the button cell to the mass fraction *b* of the binder satisfies a relationship: 0.025mAcm⁻²≤*a1*/*b≤*1mAcm⁻². Specifically, the ratio of the first peak current density *a1* of the button cell to the mass fraction *b* of the binder may be, but is not limited to, 0.025mAcm⁻², 0.03mAcm⁻², 0.05mAcm⁻², 0.08mAcm⁻², 0.1mAcm⁻², 0.15mAcm⁻², 0.18mAcm⁻², 0.2mAcm⁻², 0.25mAcm⁻², 0.28mAcm⁻², 0.35mAcm⁻², 0.3 8mAcm⁻², 0.42mAcm⁻², 0.50mAcm⁻², 0.55mAcm⁻², 0.58mAcm⁻², 0.62mAcm⁻², 0.68mAcm⁻², 0.72mAcm⁻², 0.86mAcm⁻², 0.89mAcm⁻², 0.92mAcm⁻², 0.95mAcm⁻², 0.97mAcm⁻², 1mAcm⁻², etc.

In these embodiments, when the ratio of the first peak current density *a1* of the button cell to the mass fraction *b* of the binder satisfies the relationship: 0.025mAcm⁻²≤*a1*/*b≤*1mAcm⁻², that is, the value of the first peak current density *a1* of the button cell and the value of the mass fraction *b* of the binder each are within a reasonable range, the thickness of the passivation film generated by the battery 100 during charging is within a reasonable range, so that the passivation film generated by the electrolyte 150 can prevent the electrolyte 150 from continuing to react with the positive electrode 111. Moreover, a mass proportion of the binder in the active material is within a reasonable range, which reduces the contact area between the transition metal oxide in the active material layer 1111 and the electrolyte 150, thereby further reducing the reaction heat of the positive electrode 111 and the electrolyte 150 under the overcharged state. By providing an electrolyte 150 with a suitable first peak current density and a positive electrode 111 with a binder of a suitable mass fraction, the time of continued reaction between the electrolyte 150 and the positive electrode 111 in the battery 100 in the overcharged state is shortened, and the Joule heat generated by the battery 100 in the overcharged state is reduced, thereby further improving the overcharge performance of the battery 100. When the value of *a1*/*b* is greater than 1 mAcm⁻², in the battery 100, the value of the first peak current density *a1* of the button cell is excessively large, or the value of the mass fraction *b* of the binder is excessively small. When the first peak current density *a1* of the button cell is excessively large, the thickness of the passivation film generated by the battery 100 during charging is excessively large, which leads to excessive impedance to migration of active ions in the electrolyte 150 during continued charging of the battery 100, thereby generating Joule heat. As a result, the heat generated by the battery 100 during overcharging is increased. When the value of the mass fraction b of the binder is excessively small, the contact area between the transition metal oxide in the active material layer 1111 and the electrolyte 150 is still relatively large, as a result, the binder is difficult to prevent the positive electrode 111 from reacting with the electrolyte 150 under the overcharged state, which prolongs time of continued reaction of the battery 100 in the overcharged state, and accordingly, more Joule heat and reaction heat are generated, thereby increasing risks of thermal runaway, fire, or explosion of the battery 100 caused by excessive heat. When the value of *a1*/*b* is less than 0.025 mAcm⁻², in the battery 100, the value of the first peak current density *a1* of the button cell is excessively small, or the value of the mass fraction *b* of the binder is excessively large. When the first peak current density *a1* of the button cell is excessively small, the thickness of the passivation film generated by the battery 100 during charging is excessively small, as a result, the passivation film cannot effectively passivate the positive electrode 111, and the positive electrode 111 can still continue to react with the electrolyte 150 to generate more reaction heat. When the mass fraction *b* of the binder is excessively large, impedance of the active material layer 1111 is increased, making it difficult for electrons to migrate in the active material, and making it difficult for active ions to be deintercalated from the active material layer 1111, resulting in increase in Joule heat of the battery 100 and the heat generated by the battery 100 in the overcharged state, thereby increasing risks of thermal runaway, fire, or explosion of the battery 100 caused by excessive heat.

In some embodiments, a ratio of the first peak current density *a1* of the button cell to a unit reaction area c of the active material layer 1111 satisfies the relationship: 0.24mAm⁻²≤*a1*/*c*≤12.32mAm⁻². The unit reaction area c of the active material layer 1111 is a product of a weight g of the active material layer 1111 per unit area and a specific surface area *BET* of the active material layer 1111. Specifically, the ratio of the first peak current density *a1* of the button cell to the unit reaction area c of the active material layer 1111 may be, but is not limited to, 0.24mAm⁻², 0.35mAm⁻², 0.4mAm⁻², 0.48mAm⁻², 1.2mAm⁻², 1.98mAm⁻², 2.47mAm⁻², 3.65mAm⁻², 4.23mAm⁻², 5.67mAm⁻², 5.93mAm⁻², 6.23mAm⁻², 6.79mAm⁻², 7.45mAm⁻², 7.98mAm⁻², 8.56mAm⁻², 8.99mAm⁻², 9.14mAm⁻², 10.23mAm⁻², 11.94mAm⁻², 12.32mAm⁻², etc.

It can be understood that, the value of *a1*/*c* can represent the degree of passivation of the active material layer 1111 per unit reaction area by the electrolyte 150 under the overcharged state.

It can be understood that, the weight g of the active material layer 1111 per unit area can be determined by taking a weight of the active material layer 1111 per unit area disposed on a surface of the current collector layer 1112 as the weight g.

It can be understood that, the specific surface area *BET* of the active material layer 1111 can refer to a total area of the active material layer 1111.

In these embodiments, when the ratio of the first peak current density a1 of the button cell to the unit reaction area c of the active material layer 1111 satisfies the relationship: 0.24mAm⁻²≤*a1*/*c≤* 12.32mAm⁻², the passivation film generated by the electrolyte 150 on the unit reaction area of the active material layer 1111 is within a reasonable range. Such passivation film can passivate the positive electrode 111 on the one hand, and on the other hand, can avoid increase in resistance to migration of active ions in the electrolyte 150 caused by the excessive thickness of the passivation film, so that the passivation film can prevent the reaction between the electrolyte 150 and the positive electrode 111, which can shorten the time during which the battery 100 is overcharged, thereby avoiding generation of more reaction heat and Joule heat, and preventing the separator 112 disposed between the positive electrode 111 and the negative electrode 113 from being melted and ruptured. As such, occurrence of thermal runaway of the battery 100 during overcharging can be avoided. When the value of *a1*/*c* is greater than 12.32mAm⁻², that is, the degree of passivation of the active material layer 1111 per unit reaction area by the electrolyte 150 under the overcharged state is excessively high, the passivation film generated by the electrolyte 150 on the active material layer 1111 per unit reaction area is excessively thick when the battery 100 is in the overcharged state, so that impedance of migration of active ions in the electrolyte 150 is excessively large, resulting in generation of Joule heat, thereby increasing the heat generated by the battery 100 during overcharging. When the value of *a1*/*c* is less than 0.24mAm⁻², that is, the degree of passivation of the active material layer 1111 per unit reaction area by the electrolyte 150 under the overcharged state is excessively low, the generated passivation film is difficult to passivate the positive electrode 111, as a result, the positive electrode 111 can still continue to react with the electrolyte 150 to generate more reaction heat.

In some embodiments, the unit reaction area c of the active material layer 1111 satisfies a relationship: 0.1623m²·cm⁻²≤*c*≤0.416m²·cm⁻². Specifically, the value of the unit reaction area c of the active material layer 1111 may be, but is not limited to, 0.1623m²·cm⁻², 0.17m²·cm⁻², 0.175m²·cm⁻², 0.18m²·cm⁻², 0.185m²·cm⁻², 0.2m²·cm⁻², 0.22m²·cm⁻², 0.24m²·cm⁻², 0.26m²·cm⁻², 0.28m²·cm⁻², 0.32m²·cm⁻², 0.34m²·cm⁻², 0.36m²·cm⁻², 0.38m²·cm⁻², 0.40m²·cm⁻², 0.416m²·cm⁻², etc.

In these embodiments, when the unit reaction area c of the active material layer 1111 satisfies the relationship 0.1623m²·cm⁻²≤*c*≤0.416m²·cm⁻², the unit reaction area c of the active material layer 1111 is within a reasonable range, so that active ions can be freely deintercalated from or intercalated in the active material layer 1111 during charging or discharging of the battery 100, which can avoid generation of excessive Joule heat caused by excessive impedance. When the battery 100 is in the overcharged state, the contact area between the active material layer 1111 and the electrolyte 150 is within a reasonable range, so that the passivation film generated by the electrolyte 150 can prevent the active material layer 1111 from continuing to react with the electrolyte 150, which can avoid increase of risks of thermal runaway, fire, or explosion of the battery 100 in the overcharged state, where the risks are caused by generation of more reaction heat when the active material layer 1111 reacts with the electrolyte 150 in the overcharged state. When the value of the unit reaction area c of the active material layer 1111 is greater than 0.416 m²·cm⁻², that is, the unit reaction area c of the active material layer 1111 is excessively large, the contact area between the active material layer 1111 and the electrolyte 150 is excessively large when the battery 100 is in the overcharged state, resulting in an increased reaction rate between the active material layer 1111 and the electrolyte 150, so that more reaction heat is generated when the active material layer 1111 reacts with the electrolyte 150 in the overcharged state, thereby increasing risks of thermal runaway, fire, or explosion of the battery 100 in the overcharged state. When the value of the unit reaction area c of the active material layer 1111 is less than 0.1623m²·cm⁻², that is, the unit reaction area c of the active material layer 1111 is excessively small, it is difficult for active ions to be deintercalated from the active material layer 1111 when the positive electrode 111 is assembled in the battery 100, resulting in increase in impedance of active ions migrating inside the battery 100, thereby reducing a cycle performance of the battery 100.

Referring to FIG. 1 to FIG. 5, optionally, the negative electrode 113 includes a negative material layer 1131 and a negative current collector layer 1132. The negative material layer 1131 is disposed on the negative current collector layer 1132. The negative material layer 1131 contains a negative active material, a negative conductive agent, a thickener, and a negative binder.

It can be understood that, the expression "the negative material layer 1131 is disposed on the negative current collector layer 1132" may mean that: the negative material layer 1131 is disposed on one surface of the negative current collector layer 1132, or the negative material layer 1131 is disposed on two opposite surfaces of the negative current collector layer 1132.

In these embodiments, the negative current collector layer 1132 is configured to collect a current generated by the negative active material in the negative material layer 1131 to generate a larger output current. The negative binder in the negative current collector layer 1132 is used to bond and maintain the negative current collector layer 1132, enhance the electronic contact between the negative material layer 1131 and the negative current collector layer 1132, and improve stability of the structure of the negative electrode 113. The negative conductive agent enables the positive electrode 111 to have a good charge and discharge performance, reduces a contact resistance of the negative electrode 113, and increases a migration rate of electrons in the negative material layer 1131, thereby improving the charge and discharge performance of the negative electrode 113. The thickener is used to improve uniformity of each component in the negative electrode 113, bond the negative active material, the negative conductive agent, and the thickener, which is conducive to maintaining the integrity of the structure of the negative electrode 113.

Optionally, the negative active material includes one or more of artificial graphite, natural graphite, petroleum coke, carbon fiber, or the like.

Optionally, the negative binder includes one or more of asphalt binder, styrene butadiene rubber (SBR), PVDF, polytetrafluoroethylene (PTFE), polyvinyl alcohol (PVA), polyacrylonitrile (PAN), polyacrylic acid (PAA), polyacrylate, carboxymethyl cellulose (CMC), sodium alginate, or the like.

Optionally, the negative conductive agent includes one or more of acetylene black, conductive carbon black, carbon nanotubes, carbon fiber, graphene, or the like.

Optionally, the thickener includes one or more of styrene butadiene rubber (SBR), carboxymethyl cellulose (CMC), or the like.

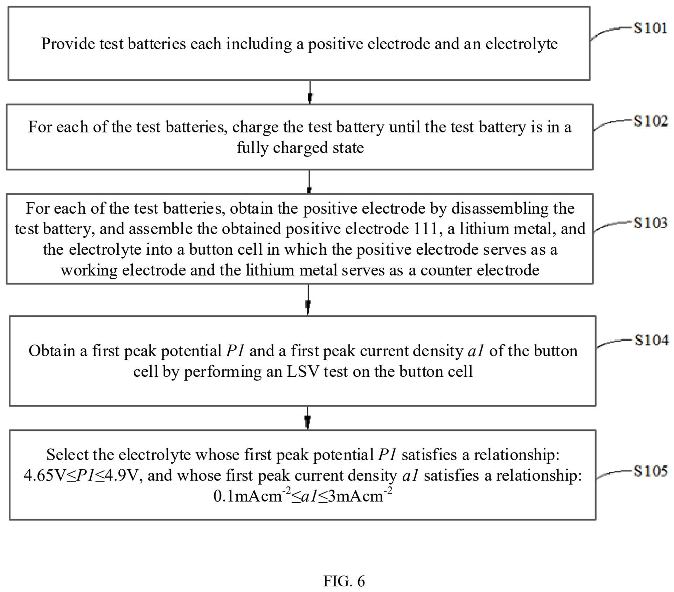

Referring to FIG. 6, the disclosure further provides an electrolyte 150 selection method. The electrolyte 150 selection method includes the following.

S101, provide test batteries each including a positive electrode 111 and an electrolyte 150.

S102, for each of the test batteries, charge the test battery until the test battery is in a fully charged state.

It can be understood that, the test battery is charged until the test battery is in the fully charged state, so that the positive electrode 111 is in a fully delithiated state.

S103, for each of the test batteries, obtain the positive electrode 111 by disassembling the test battery, and assemble the obtained positive electrode 111, a lithium metal, and the electrolyte 150 into a button cell in which the positive electrode 111 serves as a working electrode and the lithium metal serves as a counter electrode.

It can be understood that, the obtained positive electrode 111, the lithium metal, and the electrolyte 150 are assembled into the button cell, the electrolyte 150 is used to infiltrate the lithium metal and the positive electrode 111, and the button cell can be tested by applying a voltage to the button cell through an electrochemical workstation.

Further, a single-sided area 1113 of the positive electrode 111 is selected to be assembled in the button cell, and the single-sided area 1113 of the positive electrode 111 refers to an area in the positive electrode 111 where the active material layer 1111 is only disposed on one surface of the current collector layer 1112.

S104, obtain a first peak potential *P1* and a first peak current density *a1* of the button cell by performing an LSV test on the button cell.

It can be understood that, by performing the LSV test on the button cell, a characteristic first peak for the button cell can be obtained, and the first peak potential *P1* and the first peak current density *a1* of the button cell can be obtained. The first peak current density *a1* of the button cell can represent the degree of passivation of the positive electrode 111 by the electrolyte 150 when the test battery is in the fully charged state.

S105, select the electrolyte 150 whose first peak potential *P1* satisfies a relationship: 4.65V≤*P1* ≤4.9V, and whose first peak current density *a1* satisfies a relationship: 0.1mAcm⁻²≤*a1*≤3mAcm⁻².

It can be understood that, when the first peak potential *P1* of the button cell satisfies the relationship 4.65V≤*P1*≤4.9V, which indicates that: when the test battery is in the fully charged state, functional groups in the electrolyte 150 such as double bonds and cyclic structures have a polymerization reaction to form the passivation film attached to a surface of the positive electrode 111, to passivate a high-valence transition metal oxide on the positive electrode 111, which can prevent the electrolyte 150 from continuing to react with the positive electrode 111, thereby reducing generation of reaction heat. This proves that the electrolyte 150 in the test battery can form the passivation film attached to the surface of the positive electrode 111 when the battery 100 is in the fully charged state and has a good performance.

It can be understood that, when the first peak current density *a1* of the button cell satisfies the relationship: 0.1mAcm⁻²≤*a1*≤3mAcm⁻², which indicates that the thickness of the passivation film generated by the electrolyte 150 during charging is within a reasonable range. The passivation film of such thickness can passivate the positive electrode 111 on the one hand, and on the other hand, can avoid increase in resistance to migration of active ions in the electrolyte caused by the excessive thickness of the passivation film, prevent the reaction between the electrolyte 150 and the positive electrode 111, and shorten the time during which the battery 100 is overcharged, thereby avoiding generation of more reaction heat and Joule heat, and avoiding thermal runaway of the battery 100 containing the electrolyte 150 during overcharging.

In the method for selecting the positive electrode 111 provided in these embodiments, the test battery is charged to make the test battery in the fully charged state, and the test battery is disassembled to obtain the positive electrode 111; by assembling the obtained positive electrode 111 and the electrolyte 150 into the button cell and performing an LSV test on the button cell, the first peak potential *P1* and the first peak current density *a1* of the button cell are obtained. By determining whether the first peak potential *P1* satisfies the relationship: 4.65V≤*P1*≤4.9V, and determining whether the first peak current density *a1* satisfies the relationship: 0.1mAcm^{-*2*}≤*a1*≤3mAcm⁻², it is concluded whether the electrolyte 150 generates the flexible organic polymer to form the passivation film when the battery 100 is in the fully charged state and whether the thickness of the formed passivation film is within a reasonable range, so that the battery containing such electrolyte 150 has an excellent overcharge performance and an excellent cycle performance. In response to testing that the first peak potential *P1* of the button cell satisfies the relationship: 4.65V≤*P1*≤ 4.9V, and the first peak current density *a1* satisfies the relationship: 0.1mAcm⁻²≤*a1*≤3mAcm⁻*²,* the electrolyte 150 is selected to be the electrolyte 150 having an excellent performance, and the passivation film is relatively dense; when such electrolyte 150 is assembled in the battery 100, such electrolyte 150 can generate the passivation film when the battery is in the overcharged state and passivate an interface between the positive electrode 111 and the electrolyte 150, which can prevent solvent molecules in the electrolyte 150 from directly contacting and continuing to react with a transition metal oxide on the positive electrode 111. As such, generation of reaction heat can be reduced, thermal runaway of the battery 100 during overcharging can be avoided, and risks of thermal runaway, fire, or explosion of the battery 100 due to overcharging can be reduced, and therefore, an assembled battery 100 with an excellent safety performance, an excellent cycle performance, and an excellent overcharge performance is obtained.

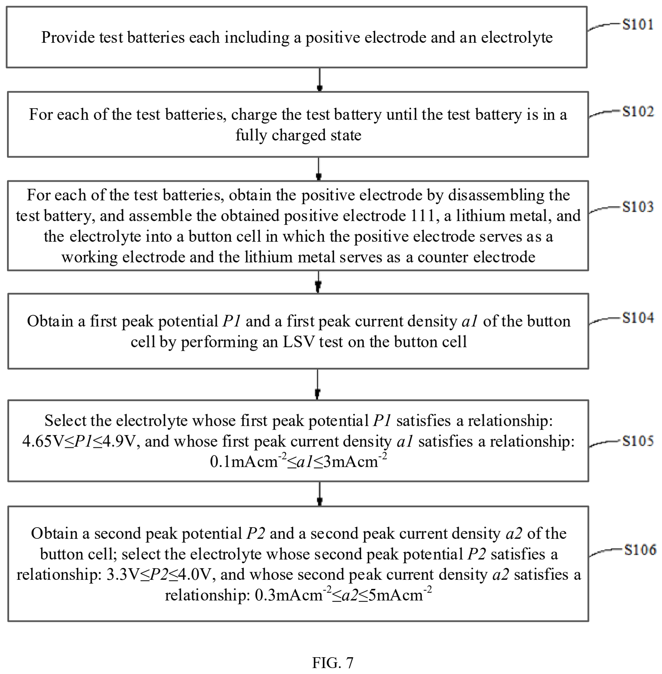

Referring to FIG. 7, optionally, in some embodiments, the electrolyte selection method further includes the following. S106, obtain a second peak potential *P2* and a second peak current density *a2* of the button cell; select the electrolyte whose second peak potential *P2* satisfies a relationship: 3.3V≤*P2*≤4.0V, and whose second peak current density *a2* satisfies a relationship: 0.3mAcm⁻²≤*a2*≤5mAcm⁻².

In the method for selecting the positive electrode 111 provided in these embodiments, the test battery is charged to make the test battery in the fully charged state, and the test battery is disassembled to obtain the positive electrode 111; by assembling the obtained positive electrode 111 and the electrolyte 150 into the button cell and performing an LSV test on the button cell, the first peak potential *P1,* the first peak current density *a1,* the second peak potential *P2*, and the second peak current density *a2* of the button cell are obtained. After evaluating the first peak potential and the first peak current density, whether the second peak potential *P2* satisfies the relationship: 3.3V≤*P2*≤4.0V, and whether the second peak current density *a2* satisfies the relationship: 0.3mAcm⁻²≤*a2*≤5mAcm⁻² are further determined, to conclude whether the battery 100 containing such electrolyte 150 generates a rigid inorganic salt compound under the overcharged state, so that the inorganic salt compound combines with the organic polymer to form the passivation film with a good structural strength and a thickness within a reasonable range, and therefore, the battery containing such electrolyte 150 has an excellent overcharge performance and an excellent cycle performance. In response to testing that the second peak potential *P2* of the button cell satisfies the relationship: 3.3V≤*P2*≤4.0V, and the second peak current density *a2* satisfies the relationship: 0.3mAcm⁻²≤*a2*≤5mAcm⁻², the electrolyte 150 is selected to be the electrolyte 150 having an excellent performance; when such electrolyte 150 is assembled in the battery 100, such electrolyte 150 can generate the passivation film with the good structural strength when the battery is in the overcharged state and passivate an interface between the positive electrode 111 and the electrolyte 150, which can prevent solvent molecules in the electrolyte 150 from directly contacting and continuing to react with a transition metal oxide on the positive electrode 111. As such, generation of reaction heat can be reduced, thermal runaway of the battery 100 during overcharging can be avoided, and risks of thermal runaway, fire, or explosion of the battery 100 due to overcharging can be reduced, and therefore, an assembled battery 100 with an excellent safety performance, an excellent cycle performance, and an excellent overcharge performance is obtained.

Optionally, in some embodiments, obtaining the first peak potential *P1* and the first peak current density *a1* of the button cell by performing the LSV test on the button cell includes: performing the LSV test on the button cell at a potential sweep rate of 0.1mV/s.

In these embodiments, when the button cell is subjected to the LSV test at a potential sweep rate of 0.1 mV/s, the potential sweep rate is within a reasonable range, which is conducive to improving accuracy of testing of the button cell.

In the following, technical solutions of the disclosure will be described in detail with reference to multiple examples.

Examples 1 to 23 and Comparative Examples 1 to 4 are provided.

### 1. Preparation of positive electrode 111:

A positive active material (e.g., lithium iron phosphate), a conductive agent (e.g., conductive carbon black, SP), and a binder (e.g., PVDF) at a certain mass ratio are dispersed into a solvent N-methylpyrrolidone (NMP), and then thoroughly mixed to obtain positive-electrode slurry. The positive-electrode slurry is coated on a positive-current-collector aluminum foil to form an active material layer 1111. The positive electrode 111 is obtained after drying, cold pressing, slitting, and cutting. In Examples 1 to 23 and Comparative Examples 1 to 4, a weight of the active material layer 1111 per unit area in the positive electrode 111, the specific surface area of the active material layer 1111, the unit reaction area c of the active material layer 1111, and a mass fraction b of the binder are as shown in Table 1, where the unit reaction area c of the active material layer 1111 is a product of a weight g of the active material layer 1111 per unit area and the specific surface area *BET* of the active material layer 1111.

### 2. Preparation of negative electrode 113:

A negative active material (e.g., artificial graphite), a negative conductive agent (e.g., conductive carbon black, SP), a thickener (e.g., carboxymethyl cellulose, "CMC" for short), and a negative binder (e.g., styrene butadiene rubber, "SBR" for short) at a mass ratio of 96.5:0.5:1:2 are dispersed into deionized water, and then thoroughly mixed to obtain negative-electrode slurry. The negative-electrode slurry is coated on a negative-current-collector aluminum foil to form a negative material layer 1131. The negative electrode 113 is obtained after drying, cold pressing, slitting, and cutting.

### 3. Preparation of separator 112:

A polyethylene film of 16um is used as the separator 112.

### 4. Preparation of electrolyte 150:

In a glovebox filled with an argon atmosphere where a moisture content is less than or equal to 1 ppm, ethylene carbonate (EC), dimethyl carbonate (DMC), and ethyl methyl carbonate (EMC) are mixed at a mass ratio of 1: (0.5-2): (0.5-2); subsequently, dried electrolyte (e.g., lithium hexafluorophosphate, LiPF₆) is dissolved into the solvent mixture and then stirred until completely and uniformly dissolved; further, at least one of vinylene carbonate (VC), fluoroethylene carbonate (FEC), ethylene sulfate (DTD), or 1,3-propane sultone (PST) is added and mixed uniformly to obtain the electrolyte 150, where raw material components of each electrolyte 150 in Examples 1 to 23 and Comparative Examples 1 to 4 are shown in Table 2.

### 5. Preparation of battery 100:

The prepared positive electrode 111, the prepared separator 112, and the prepared negative electrode 113 are stacked sequentially, and then wound to obtain an electrode assembly 110, where the separator 112 is disposed between the positive electrode 111 and the negative electrode 113. The electrode assembly 110 is assembled in a receiving chamber 141. The electrode assembly 110 is electrically connected with an end cover assembly 120 through an electrical connector 130. After drying, the prepared electrolyte 150 is injected into the receiving chamber 141. After the electrode assembly 110 is subjected to processes such as packaging, standing, forming, shaping, and capacity testing, the battery 100 is prepared.

The battery 100 in each Example of Examples 1 to 23 and Comparative Examples 1 to 4 is prepared according to the above method. The capacity of the electrode assembly 110 of the battery 100 in each Example of Examples 1 to 23 and Comparative Examples 1 to 4 is shown in Table 1.

### Performance test of battery 100:

1. The positive electrode 111 and the electrolyte 150 in each Example of Examples 1 to 23 and Comparative Examples 1 to 4 are assembled into a button cell, and an LSV test is performed on the button cell. The specific operations are as follows.
   (1) For the battery 100, the battery 100 is subjected to constant-current charging at a current of 0.5C until a voltage of the battery 100 reaches a rated voltage of 3.65V, and then the battery 100 is subjected to constant-voltage charging at a voltage of 3.65V until a current of the battery 100 reaches a rated current of 0.05C, so that the battery 100 is in a fully charged state, where "C" represents a designed capacity of the battery 100, the current of 1C refers to a current intensity when the full capacity of the battery 100 is discharged in 1 hour, the current of 0.5C refers to a current intensity when the full capacity of the battery 100 is discharged in 2 hours, and the current of 0.05C refers to a current intensity when the full capacity of the battery 100 is discharged in 20 hours.
   (2) When the battery 100 is in the fully charged state, the battery 100 is disassembled, and a single-sided area 1113 of the obtained positive electrode 111 and the electrolyte 150 are assembled into the button cell. The button cell includes a working electrode, a counter electrode, and the electrolyte 150. The electrolyte 150 infiltrates the working electrode and the counter electrode. The single-sided area 1113 of the positive electrode 111 serves as the working electrode, and a lithium metal serves as the counter electrode. A voltage is applied to the button cell through an electrochemical workstation. An open circuit voltage of the button cell is 7V.
   (3) At 25°C, the button cell is subjected to the LSV test at 0.1mV/s to obtain a first peak potential and a first peak current density of the button cell.
      The value of the first peak current density *a1* of the button cell in each Example of Examples 1 to 23 and Comparative Examples 1 to 4 is shown in Table 1, and the value of the first peak potential *P1* of the button cell in each Example of Examples 1 to 23 and Comparative Examples 1 to 4 is shown in Table 1.
2. The capacity in each Example of Examples 1 to 23 and Comparative Examples 1 to 4 is tested. The specific operations are as follows.
   (1) The battery 100 is charged at a constant power of 0.5P to a charging cut-off voltage of the battery 100, an initial charging capacity is recorded, and let the battery 100 stand for 10 minutes.
   (2) The battery 100 is discharged at the constant power of 0.5P to a discharging cut-off voltage of a single cell of the battery 100, and a discharging capacity of the battery 100 is recorded, where "P" represents a rated charging or discharging power of the battery, and "P" has a value equal to a nominal voltage U of the battery multiplied by the current density of 1C. Exemplarily, a nominal voltage of a lithium iron phosphate battery is 3.2V, and "0.5P" refers to 0.5 times the rated power.

The value of the capacity of the battery 100 in each Example of Examples 1 to 23 and Comparative Examples 1 to 4 is shown in Table 1. Various performance parameters of the above prepared battery 100 in each Example of Examples 1 to 23 and Comparative Examples 1 to 4, such as the weight of the active material layer 1111 per unit area in the positive electrode 111, the specific surface area of the active material layer 1111, the unit reaction area c of the active material layer 1111, the mass fraction *b* of the binder, the capacity of the electrode assembly 110, the first peak current density *a1* of the button cell, the first peak potential *P1* of the button cell, and the capacity of the battery 100, are recorded in Table 1.

**Table 1: performance parameters of each battery 100 in Examples 1 to 23 and Comparative Examples 1 to 4**

| Examples and Comparati -ve Examples | Capacity of battery (Ah) | First peak current densit y *a1* (mA cm⁻²) | Second peak current density *a2* (mA cm⁻²) | Mass fraction of binder *b* (%) | Weight of active material layer per unit area *W* (g/cm²) | Specific surface area of active material layer *BET* (m²/g) | Unit reaction area of active material layer *c* (m²/cm² ) | *a2*/*a 1* | *a1*/*b* (mA cm⁻²) | *a1*/*c* (mAm ⁻²) |
|---|---|---|---|---|---|---|---|---|---|---|
| Example 1 | 280 | 3 | 0.3 | \ | 0.019 | 13 | 0.25 | 0.1 | \ | 11.85 |
| Example 2 | 280 | 0.2 | 1 | \ | 0.019 | 13 | 0.25 | 5.0 | \ | 0.79 |
| Example 3 | 280 | 0.1 | 3 | \ | 0.019 | 13 | 0.25 | 30.0 | \ | 0.39 |
| Example 4 | 280 | 0.2 | 5 | \ | 0.019 | 13 | 0.25 | 25.0 | \ | 0.79 |
| Example 5 | 280 | 0.2 | 10 | \ | 0.019 | 13 | 0.25 | 50.0 | \ | 0.79 |
| Example 6 | 280 | 0.2 | 3 | \ | 0.019 | 13 | 0.25 | 15.0 | \ | 0.79 |
| Example 7 | 280 | 0.5 | 3 | \ | 0.019 | 13 | 0.25 | 6.0 | \ | 1.97 |
| Example 8 | 280 | 1 | 3 | \ | 0.019 | 13 | 0.25 | 3.0 | \ | 3.95 |
| Example 9 | 280 | 3 | 3 | \ | 0.019 | 13 | 0.25 | 1.0 | \ | 11.85 |
| Example 10 | 280 | 5 | 3 | \ | 0.019 | 13 | 0.25 | 0.6 | \ | 19.75 |
| Example 11 | 280 | 0.2 | 3 | 1 | 0.019 | 13 | 0.25 | 15.0 | 0.2 | 0.79 |
| Example 12 | 280 | 0.2 | 3 | 2 | 0.019 | 13 | 0.25 | 15.0 | 0.1 | 0.79 |
| Example 13 | 280 | 0.2 | 3 | 2.5 | 0.019 | 13 | 0.25 | 15.0 | 0.08 | 0.79 |
| Example 14 | 280 | 0.2 | 3 | 3 | 0.019 | 13 | 0.25 | 15.0 | 0.07 | 0.79 |
| Example 15 | 280 | 0.2 | 3 | 4 | 0.019 | 13 | 0.25 | 15.0 | 0.05 | 0.79 |
| Example 16 | 280 | 0.2 | 3 | 6 | 0.019 | 13 | 0.25 | 15.0 | 0.03 | 0.79 |
| Example 17 | 280 | 3 | 3 | 2 | 0.016 | 13 | 0.21 | 1.0 | 1.5 | 14.22 |
| Example 18 | 280 | 3 | 3 | 3 | 0.019 | 13 | 0.25 | 1.0 | 1.00 | 11.85 |
| Example 19 | 280 | 0.1 | 3 | 4 | 0.026 | 16 | 0.42 | 30.0 | 0.02 5 | 0.24 |
| Example 20 | 280 | 0.2 | 3 | 4 | 0.019 | 16 | 0.31 | 15.0 | 0.05 0 | 0.64 |
| Example 21 | 280 | 0.2 | 3 | 4 | 0.019 | 20 | 0.39 | 15.0 | 0.05 0 | 0.51 |
| Example 22 | 280 | 2 | 3 | 2 | 0.016 | 10 | 0.16 | 1.5 | 1.00 | 12.32 |
| Example 23 | 280 | 2 | 3 | 1 | 0.016 | 6 | 0.10 | 1.5 | 1.00 | 20.54 |
| Comparati -ve Example 1 | 50 | \ | \ | \ | \ | \ | \ | \ | \ | \ |
| Comparati -ve Example 2 | 100 | \ | \ | \ | \ | \ | \ | \ | \ | \ |
| Comparati -ve Example 3 | 200 | \ | \ | \ | \ | \ | \ | \ | \ | \ |
| Comparati -ve Example 4 | 280 | \ | \ | \ | \ | \ | \ | \ | \ | \ |

**Table 2: raw material components of each electrolyte 150 in Examples 1 to 23 and Comparative Examples 1 to 4**

| Examples and Comparative Examples | Raw material components of electrolyte |
|---|---|
| Example 1 | 12.5% LiPF₆; EC:DMC:EMC=2:1:1; 2%VC+2%FEC+1%DTD+0.3%PST |
| Example 2 | 12.5% LiPF₆; EC:DMC:EMC=2:1:2; 1%VC+0.5%FEC+2%DTD+0.3%PST |
| Example 3 | 12.5% LiPF₆; EC:DMC:EMC=2:1:4; 0.5%VC+0.5%FEC+1.5%DTD+1%PST |
| Example 4 | 12.5% LiPF₆; EC:DMC:EMC=2:2:1; 1%VC+0.5%FEC+2%DTD+0.5%PST |
| Example 5 | 12.5% LiPF₆; EC:DMC:EMC=2:4:1; 1%VC+1%FEC+2%DTD+2%PST |
| Example 6 | 12.5% LiPF₆; EC:DMC:EMC=1:2:2; 1%VC+0.5%FEC+1%DTD+1.2%PST |
| Example 7 | 12.5% LiPF₆; EC:DMC:EMC=1:2:3; 1%VC+1%FEC+1%DTD+1.5%PST |
| Example 8 | 12.5% LiPF₆; EC:DMC:EMC=2:3:1; 1.5%VC+1.5%FEC+1%DTD+1.5%PST |
| Example 9 | 12.5% LiPF₆; EC:DMC:EMC=2:3:2; 2%VC+1.5%FEC+2%DTD+0.5%PST |
| Example 10 | 12.5% LiPF₆; EC:DMC:EMC=1:1:1; 4%VC+2.5%FEC+2%DTD+0.5%PST |
| Example 11 | 12.5% LiPF₆; EC:DMC:EMC=1:2:2; 1%VC+0.5%FEC+1%DTD+1.2%PST |
| Example 12 | 12.5% LiPF₆; EC:DMC:EMC=1:2:2; 1%VC+0.5%FEC+1%DTD+1.2%PST |
| Example 13 | 12.5% LiPF₆; EC:DMC:EMC=1:2:2; 1%VC+0.5%FEC+1%DTD+1.2%PST |
| Example 14 | 12.5% LiPF₆; EC:DMC:EMC=1:2:2; 1%VC+0.5%FEC+1%DTD+1.2%PST |
| Example 15 | 12.5% LiPF₆; EC:DMC:EMC=1:2:2; 1%VC+0.5%FEC+1%DTD+1.2%PST |
| Example 16 | 12.5% LiPF₆; EC:DMC:EMC=1:2:2; 1%VC+0.5%FEC+1%DTD+1.2%PST |
| Example 17 | 12.5% LiPF₆; EC:DMC:EMC=1:1:1; 2%VC+1.5%FEC+2%DTD+0.5%PST |
| Example 18 | 12.5% LiPF₆; EC:DMC:EMC=1:1:1; 2%VC+1.5%FEC+2%DTD+0.5%PST |
| Example 19 | 12.5% LiPF₆; EC:DMC:EMC=1:1:1; 1%VC+1%DTD+1.2%PST |
| Example 20 | 12.5% LiPF₆; EC:DMC:EMC=1:2:2; 1%VC+0.5%FEC+1%DTD+1.2%PST |
| Example 21 | 12.5% LiPF₆; EC:DMC:EMC=1:2:2; 1%VC+0.5%FEC+1%DTD+1.2%PST |
| Example 22 | 12.5% LiPF₆; EC:DMC:EMC=1:1:1; 2.5%VC+2%DTD+0.5%PST |
| Example 23 | 12.5% LiPF₆; EC:DMC:EMC=1:1:1; 2.5%VC+2%DTD+0.5%PST |
| Comparative Example 1 | 12.5% LiPF₆; EC:DMC:EMC=1:1:1 |
| Comparative Example 2 | 12.5%LiPF₆; EC:DMC:EMC=1:1:1 |
| Comparative Example 3 | 12.5% LiPF₆; EC:DMC:EMC=1:1:1 |
| Comparative Example 4 | 12.5% LiPF₆; EC:DMC:EMC=1:1:1 |

2%VC+2%FEC+1%DTD+0.3%PST means that in the electrolyte 150, the mass fraction of VC is 2%, the mass fraction of FEC is 2%, the mass fraction of DTD is 1%, and the mass fraction of PST is 0.3%.

Electrochemical performance test of battery 100:

### 1. Cycle performance test:

The battery 100 is subjected to a charge-discharge cycle test on a charge and discharge instrument at a test temperature of 25°C, with a cycle rate of 1C (i.e., a charging rate and a discharging rate each are 1C) and a charging voltage ranging from 2.5V to 3.65V, and a capacity retention rate after cycling is calculated. The formula for calculating the capacity retention rate of the battery 100 cycled at 25°C is as follows: the capacity retention rate after the n^{th} cycle = (the discharging capacity after the n^{th} cycle / the discharging capacity after the first cycle) × 100%.

The capacity retention rate of the battery 100, in each Example of Examples 1 to 23 and Comparative Examples 1 to 4, after 1000 cycles at 25°C is shown in Table 3. The capacity retention rate of the battery 100 after 1000 cycles at 25°C = (the discharging capacity after the 1000^{th} cycle / the discharging capacity after the first cycle) × 100%.

### 2. Safety overcharge test:

The battery 100 is tested on the charge and discharge instrument, and let the battery 100 stand for 5 hours at a temperature ranging from 23°C to 27°C (e.g. 23°C, 25°C, 2°C, or 27°C); the battery 100 is discharged to 2.5V at 1C, and charged to 3.65V at 1C, and let the battery 100 stand for 10 minutes. Then, the battery 100 is transferred to an overcharge test instrument for testing, the battery 100 is charged at a constant current of 1C until a voltage of the device reaches 5.475V or a charging time lasts 1 hour, the battery 100 is observed for 1 hour, and records are made regarding whether any swelling, leakage, smoking, fire, or explosion occurs. The criteria for the overcharge performance of the battery 100 is: first-level compliance: the battery 100 has no leakage; second-level compliance: the battery 100 has leakage but no smoke or thermal runaway; third-level compliance: the battery 100 has leakage, smoke, and thermal runaway, but no fire or explosion; fourth-level compliance (i.e., non-compliance): the battery 100 catches fire or explodes.

The criteria for determining thermal runaway is: 1) a voltage of a test object is less than or equal to 1.0V; 2) a sampling frequency for temperature monitoring is 1s, and a temperature rise rate of a monitoring point is greater than or equal to 5°C/s for three consecutive times. When case 1) and case 2) occur in the battery 100, it is determined that thermal runaway has occurred in the battery 100.

The overcharge performance of the battery 100 in each Example of Examples 1 to 23 and Comparative Examples 1 to 4 is shown in Table 3.

The capacity retention rate of the battery 100 after 1000 cycles at 25° C and the overcharge performance of the battery 100, in each Example of Examples 1 to 23 and Comparative Examples 1 to 4, measured above are shown in Table 3.

**Table 3: electrochemical performance parameters of each battery 100 in Examples 1 to 23 and Comparative Examples 1 to 4**

| Examples and Comparative Examples | Capacity retention rate of battery after 1000 cycles at 25° C | Overcharge performance of battery |
|---|---|---|
| Example 1 | 80.30% | third-level compliance |
| Example 2 | 79.10% | third-level compliance |
| Example 3 | 78.80% | third-level compliance |
| Example 4 | 79.40% | third-level compliance |
| Example 5 | 73.20% | non-compliance |
| Example 6 | 79.40% | third-level compliance |
| Example 7 | 83.30% | second-level compliance |
| Example 8 | 85.40% | second-level compliance |
| Example 9 | 82.70% | third-level compliance |
| Example 10 | 79.20% | non-compliance |
| Example 11 | 82.50% | third-level compliance |
| Example 12 | 83.60% | second-level compliance |
| Example 13 | 83.90% | second-level compliance |
| Example 14 | 81.50% | first-level compliance |
| Example 15 | 79.80% | second-level compliance |
| Example 16 | 71.40% | second-level compliance |
| Example 17 | 81.90% | third-level compliance |
| Example 18 | 81.90% | third-level compliance |
| Example 19 | 75.50% | second-level compliance |
| Example 20 | 82.40% | first-level compliance |
| Example 21 | 74.20% | first-level compliance |
| Example 22 | 75.70% | third-level compliance |
| Example 23 | 69.80% | third-level compliance |
| Comparative Example 1 | 75.60% | second-level compliance |
| Comparative Example 2 | 73.50% | second-level compliance |
| Comparative Example 3 | 72.40% | non-compliance |
| Comparative Example 4 | 70.70% | non-compliance |

Referring to Table 1 to Table 3, as can be seen from the performance parameters and the electrochemical performance parameters of the battery 100 in each of Examples 1 to 5, particularly Examples 2, 4, and 5, under otherwise unchanged conditions, as the value of the second peak current density *a2* continuously increases, the value of *a2*/*a1* and the value of *a1*/*c* continuously increases. In this case, the capacity retention rate of the battery 100 after 1000 cycles at 25°C is reduced, the overcharge performance of the battery 100 in Example 2 is third-level compliance, the overcharge performance of the battery 100 in Example 4 is third-level compliance, and the overcharge performance of the battery 100 in Example 5 is non-compliance. This is because: for the battery 100 in Example 2 and the battery 100 in Example 4, the value of *a2* and the value of *a2*/*a1* each are within a reasonable range, while for the battery 100 in Example 5, the value of *a2* is greater than 5 mA cm⁻² and the value of *a2*/*a1* is greater than 30, that is, the value of *a2* and the value of *a2*/*a1* each are excessively large, so that an excessive amount of the rigid inorganic salt compound is generated by the electrolyte 150 during overcharging, while an insufficient amount of the flexible organic polymer is generated by the electrolyte 150 during overcharging. As a result, when the rigid inorganic salt compound is combined with the flexible organic polymer to form the passivation film, the formed passivation film is too rough and not dense, which leads to decrease in an effect of passivation of the positive electrode 111 by the passivation film, thereby reducing the overcharge performance of the electrolyte 150. Consequently, the capacity retention rate of the battery 100 in Example 5 is lower than that of the battery 100 in each of Examples 2 and 4, and the overcharge performance of the battery 100 in Example 5 is inferior to that of the battery 100 in each of Examples 2 and 4. As can be seen from data of Example 1 and Example 3, for the battery 100 in Example 1, the first peak current density *a1* is 3 mAcm⁻², and the value of *a2*/*a1* is 0.1; for the battery 100 in Example 3, the first peak current density *a1* is 0.1 mAcm⁻², and the value of *a2*/*a1* is 30.0. In this case, the thickness of the passivation film generated by the battery 100 in each of Examples 1 and 3 during charging is within a reasonable range, and the structural strength, compactness, and thickness of the generated passivation film each are within a reasonable range. Such passivation film can passivate the positive electrode 111 on the one hand, and on the other hand, can avoid increase in resistance to migration of active ions in the electrolyte 150 caused by the excessive thickness of the passivation film, prevent the reaction between the electrolyte 150 and the positive electrode 111, and shorten the time during which the battery 100 is overcharged, thereby avoiding generation of more reaction heat and Joule heat, and preventing the separator 112 disposed between the positive electrode 111 and the negative electrode 113 from being melted and ruptured. As such, thermal runaway of the battery 100 during overcharging can be avoided. Consequently, the overcharge performance and the capacity retention rate of the battery 100, in Example 1 and Example 3, after 1000 cycles at 25°C are relatively good, that is, the battery 100 has an excellent safety performance and an excellent cycle performance.

As can be seen from the performance parameters and the electrochemical performance parameters of the battery 100 in each of Example 3 and Examples 6 to 10, under otherwise unchanged conditions, as the value of the first peak current density *a1* continuously increases, the value of *a2*/*a1* continuously decreases, and the value of *a1*/*c* continuously increases on condition that the unit reaction area c of the active material layer 1111 remains unchanged. In this case, the capacity retention rate of the battery 100 after 1000 cycles at 25°C first increases and then decreases, and the overcharge performance of the battery 100 first increases and then decreases; the overcharge performance of the battery 100 in Example 3 is third-level compliance, the overcharge performance of the battery 100 in Example 6 is third-level compliance, the overcharge performance of the battery 100 in Example 7 is second-level compliance, the overcharge performance of the battery 100 in Example 8 is second-level compliance, the overcharge performance of the battery 100 in Example 9 is third-level compliance, and the overcharge performance of the battery 100 in Example 10 is non-compliance. This is because, for the battery 100 in each of Example 3 and Examples 6 to 9, the value of the first peak current density *a1* of the button cell satisfy the relationship: 0.1 mAcm⁻²≤*a1*≤3 mAcm⁻², and the value of *a2*/*a1* satisfy 0.1≤*a2*/*a1*≤30, that is, the value of the first peak current density *a1* of the button cell in each of Example 3 and Examples 6 to 9 is within a reasonable range, so that the thickness of the passivation film generated by the battery 100 during charging is within a reasonable range and the values of *a1* in Example 3 and Examples 6 to 9 increase sequentially. Such passivation film can passivate the positive electrode 111 on the one hand, and on the other hand, can avoid increase in resistance to migration of active ions in the electrolyte 150 caused by the excessive thickness of the passivation film, prevent the reaction between the electrolyte 150 and the positive electrode 111, and shorten the time during which the battery 100 is overcharged, thereby avoiding generation of more reaction heat and Joule heat, and preventing the separator 112 disposed between the positive electrode 111 and the negative electrode 113 from being melted and ruptured. As such, thermal runaway of the battery 100 during overcharging can be avoided. Consequently, the overcharge performance and the capacity retention rate of the battery 100 after 1000 cycles at 25°C can be improved gradually, that is, the safety performance and the cycle performance of the battery 100 can be improved. Since the value of the first peak current density *a1* in Example 10 is greater than 3mAcm⁻², the thickness of the passivation film generated by the battery 100 during charging is excessively large, and accordingly, the degree of passivation of the positive electrode 111 by the electrolyte 150 is excessively high, which leads to excessive impedance to migration of active ions in the electrolyte 150 during continued charging of the battery 100. As a result, Joule heat is generated, which increases the heat generated by the battery 100 during overcharging, thereby reducing the overcharge performance and the capacity retention rate of the battery 100 after 1000 cycles at 25°C, that is, reducing the safety performance and the cycle performance of the battery 100. In addition, no characteristic first peak appears in results of the LSV test conducted on the batteries 100 in Comparative Examples 1 to 4, so that the electrolyte 150 cannot form the passivation film when the battery 100 is in the overcharged state, as a result, continued reaction of the electrolyte 150 and the positive electrode 111 cannot be prevented, so that the battery 100 generates more reaction heat and Joule heat under the overcharged state. For Comparative Examples 1 to 4, as the capacity of the battery 100 continuously increases, the heat generated by the battery 100 in the overcharged state continuously increases, but the electrolyte 150 in Comparative Examples 1 to 4 cannot prevent the reaction of the battery 100 in the overcharged state, as a result, the overcharge performance and the capacity retention rate of the battery 100 after 1000 cycles at 25° C continuously decreases, that is, the safety performance and the cycle performance of the battery 100 in Comparative Examples 1 to 4 are successively reduced.

Further, as can be seen from the performance parameters and the electrochemical performance parameters of the battery 100 in each of Example 6 and Examples 11 to 16, under otherwise unchanged conditions, as the mass fraction b of the binder in the active material layer 1111 continuously increases, the value of *a1*/*b* continuously increases, the capacity retention rate of the battery 100 after 1000 cycles at 25°C first increases and then decreases, and the overcharge performance of the battery 100 first increases and then decreases; the overcharge performance of the battery 100 in Example 6 is third-level pass, the overcharge performance of the battery 100 in Example 11 is third-level compliance, the overcharge performance of the battery 100 in Example 12 is second -level compliance, the overcharge performance of the battery 100 in Example 13 is second -level compliance, the overcharge performance of the battery 100 in Example 14 is first-level compliance, the overcharge performance of the battery 100 in Example 15 is second-level compliance, and the overcharge performance of the battery 100 in Example 16 is second-level compliance. In Examples 12 to 15, the mass fraction b of the binder in the active material layer 1111 satisfies the relationship: 2%≤*b*≤4%, that is, the mass fraction of the binder is within a reasonable range; as the mass fraction of the binder in the active material layer 1111 gradually increases, a contact area between the transition metal oxide in the active material layer 1111 and the electrolyte 150 gradually decreases, which can further reduce the reaction heat of the positive electrode 111 and the electrolyte 150 under the overcharged state. In addition, by providing more binder in the active material layer 1111, the reaction between the electrolyte 150 and the positive electrode 111 under the overcharged state can be further rapidly suppressed, which is beneficial to shortening the time of continued reaction of the battery 100 in the overcharged state, and accordingly, reducing Joule heat generated under the overcharged state, thereby further improving the overcharge performance of the battery 100. As such, the overcharge performance and the capacity retention rate of the battery 100 after 1000 cycles at 25°C can be gradually improved, that is, the safety performance and the cycle performance of the battery 100 can be improved. No binder is provided in the active material layer 1111 in Example 6, and the mass fraction b of the binder in Example 11 is less than 2%, in this case, the contact area of the transition metal oxide in the active material layer 1111 and the electrolyte 150 is still relatively large, as a result, the binder is difficult to prevent the positive electrode 111 from reacting with the electrolyte 150 under the overcharged state, which prolongs time of continued reaction of the battery 100 in the overcharged state, and accordingly, more Joule heat and reaction heat are generated. Consequently, compared to the batteries 100 in each of Examples 12 to 15, the overcharge performance and the capacity retention rate of the batteries 100, in each of Example 6 and Example 11, after 1000 cycles at 25°C are poorer. Further, for the battery 100 in Example 16, the mass fraction b of the binder is greater than 4%, which increases impedance of the active material layer 1111, making it difficult for electrons to migrate in the active material, and making it difficult for active ions to be deintercalated from the active material layer 1111, resulting in increase in Joule heat of the battery 100 and increase in the heat generated by the battery 100 in the overcharged state, thereby reducing the cycle performance and the overcharge performance of the battery 100. In Comparative Examples 1 to 4, no binder is provided in the active material layer 1111 of the battery 100, as a result, the reaction time of the battery 100 in the overcharged state cannot be further shortened, so that the cycle performance and the overcharge performance of the batteries 100 in each of Comparative Examples 1 to 4 are relatively poor.

Further, as can be seen from the performance parameters and the electrochemical performance parameters of the battery 100 in each of Examples 17 to 23, the value of the first peak current density *a1,* the second peak current density *a2,* and the value of *a2*/*a1* in each of Examples 17 to 13 are all within a reasonable range. For the battery 100 in each of Examples 18, 20, and 21, the value of the c satisfies 0.1623m²·cm⁻²≤*c*≤0.416m²·cm⁻², the value of *a1*/*b* satisfies 0.025mAcm⁻²≤*a1*/*b*≤1mAcm⁻², and the value of *a1*/*c* satisfies 0.24mAm⁻²≤*a1*/*c*≤12.32mAm⁻², so that the capacity retention rate of the battery 100, in each of Examples 18 and 20, after 1000 cycles at 25°C, and the overcharge performance of the battery 100 in Example 21 is first-level compliance, in this case, the battery 100 in Example 21 has a good overcharge performance. As can be seen from data of Example 17 and Example 18, when the mass fraction of the binder is relatively large, the mass proportion of the binder in the active material layer 1111 is relatively high, which reduces the contact area between the transition metal oxide in the active material layer 1111 and the electrolyte 150, thereby further reducing the reaction heat of reaction of the positive electrode 111 and the electrolyte 150 under the overcharged state. In addition, if the value of *a1*/*c* is relatively large, the first peak current density is relatively large, which is beneficial to improving the degree of passivation of the electrolyte 150 under the overcharged state, and thus, the batteries in Example 17 and Example 18 each have a relatively high capacity retention rate. As can be seen from data of Examples 19 to 21, as the unit reaction area c of the active material layer 1111 continuously increases, the capacity retention rate of the battery 100 after 1000 cycles at 25°C decreases. This is because: when the battery 100 is in the overcharged state, the contact area between the active material layer 1111 and the electrolyte 150 is excessively large, which increases a reaction rate between the active material layer 1111 and the electrolyte 150, as a result, the active material layer 1111 and the electrolyte 150 can generate more reaction heat under the overcharged state, which increases risks of thermal runaway, fire, or explosion of the battery 100 in the overcharged state, thereby reducing the capacity retention rate of the battery 100. As can be seen from data of Example 22 and Example 23, when the mass proportion of the binder is excessively low, the thickness of the passivation film generated by the battery 100 during charging is excessively small, as a result, it is difficult for the passivation film to passivate the positive electrode 111. In this case, the positive electrode 111 can still continue to react with the electrolyte 150 to generate more reaction heat, and accordingly, the lower the capacity retention rate of the battery 100 after 1000 cycles at 25°C, the worse the cycle performance of the battery 100.

In sum, the battery 100 can have an excellent cycle performance and an excellent overcharge performance when the battery 100 satisfies one or more of the following relationships: the value of the first peak current density *a1* satisfies: 0.1mAcm⁻²≤*a1*≤3mAcm⁻², the second peak current density *a2* of the button cell satisfies: 0.3mAcm⁻²≤*a2*≤5mAcm⁻², the ratio of the second peak current density of the button cell to the first peak current density of the button cell satisfies: 0.1 *≤a2*/*a1*≤30, the mass fraction *b* of the binder in the active material layer 1111 satisfies: 2%≤*b*≤4%, the value of *a1*/*b* satisfies: 0.025mAcm⁻²≤ *a1*/*b≤*1mAcm⁻², and the value of *a1*/*c* satisfies: 0.24mAm⁻²*≤a1*/*c≤*12.32mAm⁻². In view of the above, the overcharge performance and the capacity retention rate of the battery 100 after 1000 cycles at 25°C are excellent, that is, the battery 100 has the excellent overcharge performance and the excellent cycle performance.

It can be understood that, examples of raw material components of the electrolyte 150 in Examples 1 to 23 and Comparative Examples 1 to 4 in the disclosure are only examples of the electrolyte 150 in various embodiments, and should not be understood as a limitation on the raw material components of the electrolyte 150.

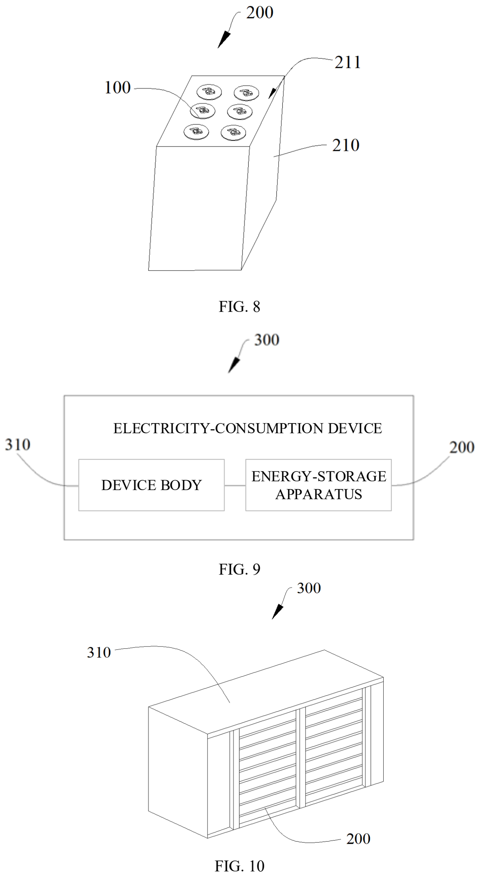

Referring to FIG. 8, embodiments of the disclosure further provide an energy-storage apparatus 200. The energy-storage apparatus 200 includes multiple batteries 100 provided in the disclosure, the multiple batteries 100 are electrically connected to each other.

In embodiments of the disclosure, the multiple batteries 100 may be electrically connected in series, in parallel, or in a mixed manner. The battery 100 can reduce generation of heat, and the battery 100 has an excellent cycle performance and an excellent overcharge performance. The multiple batteries 100 are assembled into the energy-storage apparatus 200, which is conducive to improving the cycle performance of the energy-storage apparatus 200, reducing reaction heat or Joule heat generated by the energy-storage apparatus 200 in an overcharged state, avoiding risks of thermal runaway, fire, or explosion of the energy-storage apparatus 200 caused by excessive heat, thereby improving the cycle performance and the safety performance of the energy-storage apparatus 200.

Optionally, the energy-storage apparatus 200 includes a box 210. The box 210 encloses an accommodating chamber 211 for accommodating multiple batteries 100.

Referring to FIG. 9 and FIG. 10, embodiments of the disclosure further provides an electricity-consumption device 300. The electricity-consumption device 300 includes a device body 310 and the energy-storage apparatus 200 provided in the disclosure. The energy-storage apparatus 200 is configured to supply power to the device body 310. In other words, the energy-storage apparatus 200 is electrically connected with the device body 310.

In these embodiments, the energy-storage apparatus 200 has both the excellent cycle performance and the excellent safety performance, so that the energy-storage apparatus 200 can provide a stable power supply to the device body 310, and further, the device body 310 can work stably.

The electricity-consumption device 300 of embodiments of the disclosure may be, but is not limited to, a portable electronic device such as a mobile phone, a tablet computer, a laptop computer, a desktop computer, a smart bracelet, a smart watch, an e-reader, a game console, etc. The electricity-consumption device 300 of embodiments of the disclosure may also be a transportation mean such as a car, a truck, a sedan, a freight vehicle, a truck, a bullet train, a high-speed train, an electric car, etc. In addition, the electricity-consumption device 300 of embodiments of the disclosure may also be various household appliances, etc.

It can be understood that, the electricity-consumption device 300 described in these embodiments is only a form of the electricity-consumption device 300 used by the energy-storage apparatus 200, and should not be understood as a limitation on the electricity-consumption device 300 provided in the disclosure, nor should it be understood as a limitation on the electricity-consumption device 300 provided in each embodiment of the disclosure. In embodiments of FIG. 9 of the disclosure, the electricity-consumption device 300 may be an energy-storage-battery cabinet.

The term "embodiment" and "implementation" in the disclosure means that particular features, structures, or properties described in conjunction with the embodiments may be defined in at least one embodiment of the disclosure. The phrase "embodiment" appearing in various places in the specification does not necessarily refer to the same embodiment or an independent or alternative embodiment that is mutually exclusive with other embodiments. Those skilled in the art will understand expressly and implicitly that the embodiments described herein may be combined with other embodiments. In addition, it is to be understood that, the features, structures, or properties described in the embodiments of the disclosure can be arbitrarily combined to form another embodiment that does not deviate from the spirit and scope of the technical solution of the disclosure, if there is no contradiction between them.

Finally, it is to be noted that, the foregoing embodiments are only used to illustrate the technical solution of the disclosure and are not intended to limit the disclosure. Although the disclosure is described in detail with reference to the foregoing exemplary embodiments, those skilled in the art should understand that, modifications or equivalent substitutions may be made to the technical solution of the disclosure, without departing from the spirit and scope of the technical solution of the disclosure.

## Claims

1. A battery, comprising:
an electrode assembly, the electrode assembly comprising a positive electrode, a separator, and a negative electrode which are stacked sequentially; and
an electrolyte, the electrolyte at least infiltrating part of the electrode assembly, and the electrolyte containing a lithium salt;
the positive electrode being obtained by disassembling the battery in a fully charged state, the positive electrode obtained and the electrolyte being assembled in a button cell, the button cell being subjected to a linear sweep voltammetry, LSV, test at a potential sweep rate of 0.1 mV/s, and a first peak current density *a1* of the button cell satisfying a relationship: 0.1mAcm⁻²*≤a1≤*3mAcm⁻²*.*

2. The battery of claim 1, wherein a first peak potential *P1* of the button cell satisfies: 4.65V≤*P*≤ 4.9V.

3. The battery of claim 2, wherein a second peak potential *P2* of the button cell satisfies: 3.3V≤*P2* ≤4.0V.

4. The battery of claim 3, wherein a second peak current density *a2* of the button cell satisfies: 0.3mAcm⁻²≤*a2*≤5mAcm⁻².

5. The battery of claim 1, wherein a ratio of a second peak current density of the button cell to the first peak current density of the button cell satisfies: 0.1≤*a2*/*a1≤30.*

6. The battery of any of claims 1 to 5, wherein the electrolyte further contains a film-forming additive, and in the electrolyte, a mass fraction g of the film-forming additive satisfies a relationship: 2% ≤*g*≤10%.

7. The battery of claim 6, wherein the film-forming additive comprises at least one of vinylene carbonate, fluoroethylene carbonate, vinyl sulfate, or 1,3-propene sultone.

8. The battery of claim 1, wherein the positive electrode comprises an active material layer and a current collector layer, the active material layer is disposed on the current collector layer, the active material layer contains a binder, and in the active material layer, a mass fraction b of the binder satisfies a relationship: 2%≤*b*≤4%.

9. The battery of claim 8, wherein a ratio of the first peak current density *a1* of the button cell to the mass fraction *b* of the binder satisfies a relationship: 0.025mAcm⁻²≤a1/*b≤*1mAcm⁻².

10. The battery of claim 8, wherein a ratio of the first peak current density *a1* of the button cell to a unit reaction area c of the active material layer satisfies a relationship: 0.24mAm⁻²≤*a1*/*c≤*12.32mAm⁻², wherein the unit reaction area c of the active material layer is a product of a weight g of the active material layer per unit area and a specific surface area *BET* of the active material layer.

11. The battery of claim 9, wherein the unit reaction area c of the active material layer satisfies a relationship: 0.1623m²·cm-²≤*c*≤0.416m²·cm⁻².

12. The battery of claim 8, wherein the active material layer further contains an active material, the active material is lithium iron phosphate, and the current collector layer contains aluminum.

13. The battery of claim 8, wherein the binder is polyvinylidene fluoride.

14. An electrolyte selection method, comprising:
providing test batteries each comprising a positive electrode and an electrolyte;
for each of the test batteries, charging the test battery until the test battery is in a fully charged state;
for each of the test batteries, obtaining the positive electrode by disassembling the test battery, and assembling the positive electrode obtained, a lithium metal, and the electrolyte into a button cell in which the positive electrode serves as a working electrode and the lithium metal serves as a counter electrode;
obtaining a first peak potential *P1* and a first peak current density *a1* of the button cell by performing a linear sweep voltammetry, LSV, test on the button cell; and
selecting the electrolyte whose first peak potential *P1* satisfies a relationship: 4.65V≤*P1*≤4.9V, and whose first peak current density *a1* satisfies a relationship: 0.1mAcm⁻²*≤a1*≤3mAcm⁻².

15. The electrolyte selection method of claim 14, further comprising:
obtaining a second peak potential *P2* and a second peak current density *a2* of the button cell; and
selecting the electrolyte whose second peak potential *P2* satisfies a relationship: 3.3V≤*P2*≤4.0V, and whose second peak current density *a2* satisfies a relationship: 0.3mAcm⁻²≤*a2*≤5mAcm⁻².

16. The electrolyte selection method of claim 14, wherein obtaining the first peak potential *P1* and the first peak current density *a1* of the button cell by performing the LSV test on the button cell comprises:
performing the LSV test on the button cell at a potential sweep rate of 0.1mV/s.

17. An energy-storage apparatus, comprising a plurality of batteries of any of claims 1 to 13, and the plurality of batteries being electrically connected to each other.

18. An electricity-consumption device, comprising:
a device body; and
the energy-storage apparatus of claim 17, wherein the energy-storage apparatus is configured to supply power to the device body.
